(19) Europäisches Patentamt / European Patent Office / Office européen des brevets

(11) **EP 3 576 942 B1**

(12) **EUROPEAN PATENT SPECIFICATION**

(45) Date of publication and mention of the grant of the patent:
**31.05.2023 Bulletin 2023/22**

(21) Application number: **18701190.3**

(22) Date of filing: **29.01.2018**

(51) International Patent Classification (IPC):
*B32B 7/12* ^(2006.01)     *B32B 27/08* ^(2006.01)
*B32B 27/20* ^(2006.01)     *B32B 27/30* ^(2006.01)
*B32B 27/32* ^(2006.01)

(52) Cooperative Patent Classification (CPC):
**B32B 27/32; B32B 7/12; B32B 27/08; B32B 27/20; B32B 27/308;** B32B 2250/02; B32B 2250/246; B32B 2264/102; B32B 2270/00; B32B 2457/12; Y02E 10/50

(86) International application number:
**PCT/EP2018/052071**

(87) International publication number:
**WO 2018/141672 (09.08.2018 Gazette 2018/32)**

(54) **ARTICLE COMPRISING A LAYER ELEMENT**

ARTIKEL MIT EINEM LAGENELEMENT

ARTICLE COMPRENANT UN ÉLÉMENT EN COUCHE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.02.2017 EP 17154152**

(43) Date of publication of application:
**11.12.2019 Bulletin 2019/50**

(73) Proprietor: **Borealis AG**
**1020 Vienna (AT)**

(72) Inventors:
• **BERNREITNER, Klaus**
 **4010 Linz (AT)**
• **SANDHOLZER, Martina**
 **4030 Linz (AT)**
• **HELLSTRÖM, Stefan**
 **442 42 Kungälv (SE)**
• **COSTA, Francis**
 **4040 Linz (AT)**
• **SULTAN, Bernt-Åke**
 **444 42 Stenungsund (SE)**
• **JOSEFSSON, Staffan**
 **411 31 Göteborg (SE)**
• **AKYÜZ KARLSSON, Kristina**
 **444 95 Ödsmål (SE)**

(74) Representative: **Maiwald GmbH**
**Elisenhof**
**Elisenstraße 3**
**80335 München (DE)**

(56) References cited:
**EP-A2- 2 660 877          WO-A1-2013/003541**
**WO-A1-2015/173175     US-A1- 2015 013 753**

**Description**

The present invention relates to an article comprising a layer element of at least two layers. The article is preferably a film or photovoltaic (PV) module, preferably a photovoltaic (PV) module, comprising the layer element of the invention. The invention further relates to a process for producing the layer element of the article.

**Background art**

In certain end use applications, like outdoor end use wherein temperature may vary within wide range and articles are may be exposed to sunlight, the polymeric articles have special requirements for instance with respect to mechanical properties, long-term thermal stability, especially at high temperatures, barrier properties and UV stability.

For instance photovoltaic (PV) modules, also known as solar cell modules, produce electricity from light and are used in various kinds of applications, i.a. in outdoor applications, as well known in the field. The type of the photovoltaic module can vary. The modules have typically a multilayer structure, i.e. several different layer elements which have different functions. The layer elements of the photovoltaic module can vary with respect to layer materials and layer structure. The final photovoltaic module can be rigid or flexible.

The above exemplified layer elements can be monolayer or multilayer elements. Typically the layer elements of PV module are assembled in order of their functionality and then laminated together to form the integrated PV module. Moreover, there may be adhesive layer(s) between the layers of an element or between the different layer elements.

The photovoltaic (PV) module can for example contain, in a given order, a protective front layer element which can be flexible or rigid (such as a glass layer element), front encapsulation layer element, a photovoltaic element, rear encapsulation layer element, a protective back layer element, which is also called a backsheet layer element and which can be rigid or flexible; and optionally e.g. an aluminium frame. Accordingly, part or all of the layer elements of a PV module, e.g. the front and rear encapsulation layer elements, and often the backsheet layer, are typically of a polymeric material, like ethylene vinyl acetate (EVA) based material.

In case of articles, like PV module, with multilayer element(s) the compatibility of the different layer materials may cause problems which can deteriorate the properties of the final article. The properties of the chosen layer materials may also not be sufficient to meet overall property needed for a layer element at end use of the final article.

WO 2013/00354 1 A1 discloses a multilayer film structure comprising a layer (B) that comprises a crystalline block copolymer composition or a specific block copolymer composite comprising i) an ethylene polymer comprising at least 80 mol% polymerized ethylene, ii) an alpha-olefin-based crystalline polymer and a block copolymer comprising (a) an ethylene polymer block comprising at least 80 mol% polymerized ethylene and (b) a crystalline alpha-olefin block; and a layer C that comprises a polyolefin having at least one melting peak greater than 125°C, wherein the layers C and B are in adhering contact.

WO 2015/173175 A1 discloses a photovoltaic module comprising at least one photovoltaic element and at least one layer comprising a polypropylene composition which comprises a heterophasic propylene copolymer. Said layer preferably is used as backsheet element. In the example section said backsheet element contains an adhesive layer for improving adhesion to the encapsulant.

EP 2 660 877 A2 discloses a photovoltaic module comprising a solar cell element and an insulation material laminated to at least one side of the solar cell element wherein the insulation material comprises an olefin copolymer which comprises silane group-containing monomer units, wherein cross-linking is performed by condensation of silanol groups contained in the polyolefin which are obtained by hydrolysation of silane groups. The photovoltaic module can comprise any kind of protective back or bottom cover. No information is given on how to improve adhesion of the insulation material with the protective back or bottom cover.

US 2015/0013753 A1 discloses a laminated electronic devise module comprising at least one electronic device and an ethylene interpolymer film in intimate contact with at least one surface of the electronic device comprising a surface layer comprising a silane containing ethylene interpolymer comprising (1) an ethylene interpolymer having a density of less than 0.905 g/cm$^3$, and (2) at least 0.1 5 by weight alkoxysilane, characterized by having a volume resistivity of greater than $5 \times 10^{15}$ ohm-cm as measured at 60°C. Said device module can optionally comprise a backsheet layer. No information is given on how to improve adhesion of the ethylene interpolymer film with the backsheet layer.

Accordingly, there is a continuous need for solutions of layer elements for demanding end applications, like photovoltaic module applications, to meet the challenging requirements for industrially applicable articles.

**Figures**

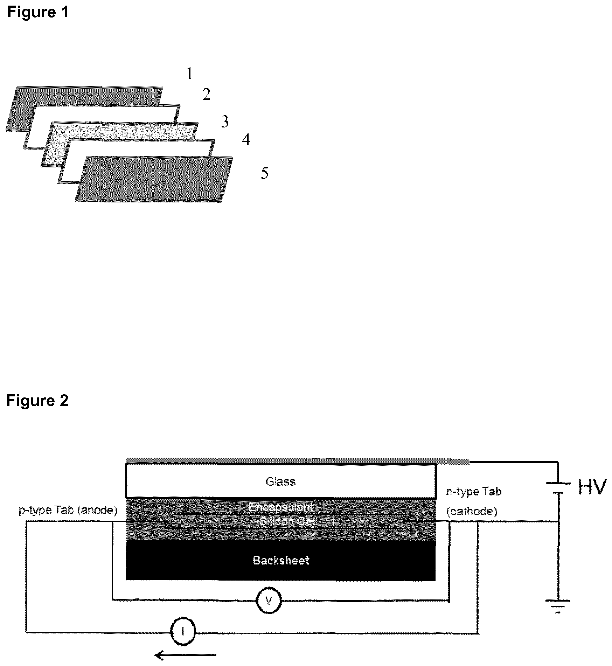

Figure 1 is a schematic picture of a typical PV module of the invention comprising a protective front layer element (1), a front encapsulation layer element (2), a photovoltaic element (3) and a layer element (LE) of the invention ((4)/(5)), which functions as a rear encapsulation layer element (4) and as a protective back layer element (5). Figure 2 is a schematic description of the PID test set-up.

**The description of the invention**

Accordingly, the present invention is directed to an article comprising a layer element (LE) of at least two layers, i.e. first layer and second layer, wherein

- the first layer comprises (a) a copolymer of ethylene which is selected from

   (a1) a copolymer of ethylene which bears silane group(s) containing units; or
   (a2) a copolymer of ethylene with one or more polar comonomer(s) selected from $(C_1-C_6)$-alkyl acrylate or $(C_1-C_6)$-alkyl $(C_1-C_6)$-alkylacrylate comonomer(s), which copolymer (a2) bears silane group(s) containing units and which copolymer (a2) is different from the copolymer (a1); and

- the second layer comprises (b) a polymer of propylene (PP),

   and wherein the first layer and second layer of the layer element (LE) are in adhering contact to each other, wherein the first layer of the layer element (LE) comprises more than 50 wt% of the copolymer of ethylene (a).

The definitions "copolymer of ethylene (a)" and "polymer of propylene (PP) (b)", as defined above, below or in claims, are referred herein also shortly as "polymer (a)" or "copolymer (a)" and respectively, as "PP polymer", "PP polymer (b)" or "polymer (b)".

The definition "(a1) copolymer of ethylene which bears silane group(s) containing units", as defined above, below or in claims, is referred herein also shortly as "copolymer of ethylene (a1)", "copolymer (a1)" or "polymer (a1)". The definition "(a2) a copolymer of ethylene with one or more polar comonomer(s) selected from $(C_1-C_6)$-alkyl acrylate or $(C_1-C_6)$-alkyl $(C_1-C_6)$-alkylacrylate comonomer(s ), which copolymer (a2) bears silane group(s) containing units and which copolymer (a2) is different from the copolymer (a1)", as defined above, below or in claims, is referred herein also shortly as "copolymer of ethylene (a2)", "copolymer (a2)" or "polymer (a2)".

As well known "comonomer" refers to copolymerisable comonomer units. Accordingly, the layer element (LE) is a multilayer element comprising at least the first layer and the second layer.

Unexpectedly, the specific two layers of the claimed layer element (LE) of the invention provide higher and consistent adhesion and easy material handling of the layer element (LE) for producing an article comprising said layer element (LE). Moreover, the claimed layer element (LE) provides a highly advantageous multifunctional layer element for different end applications. Multifunctionality is indicated herein as the combination of the properties of the first layer and the properties of the second layer, which property combination provides unexpectedly advantageous overall performance of the layer element (LE) for demanding end applications, like outdoor applications. The combination of the first layer and the second layer provides preferably inter alia one or more, or all, of the following properties: advantageous reflectivity and insulation properties, increased barrier properties (e.g. water barrier properties) and wet leakage resistance, increased mechanical properties, like high stiffness and mechanical stability (expressed e.g. HDT), resistance against hydrolysis, dimensional stability, UV and thermal stability and/or very advantageous shrinkage behavior when producing the layer element (LE) and the final article thereof.

According to one embodiment of the invention, the article is multilayer film comprising, preferably consisting of, the layer element (LE) of said at least to layers. Herein it is understood, that there may be an adhesive layer between said two layers for further enhancing the adhesion. Adhesive layers have a well-known meaning in the art and herein not calculated to an additional layer to the at least two layers. Most preferably, the layer element of said two layers does not contain any adhesive layer(s) between said two layers, i.e. the contacting surfaces of the at least two layers are without any additional adhesive layer. Accordingly, the said at least two layers are more preferably in direct adhering contact to each other.

According to another embodiment of the invention, the article is a multilayer assembly comprising two or more layer elements, wherein at least one layer element is the layer element of the invention.

The layer element of the invention is highly advantageous for example as multifunctional layer element for a photovoltaic (PV) module, wherein it can function e.g. both as a rear encapsulation element and as a backsheet element. Moreover, preferably the layer element (LE) of the invention increases the resistance against Potential Induced Degradation (PID), or even can prevent Potential Induced Degradation (PID), of a photovoltaic module.

Thus according to a further embodiment of the invention, the article of the invention is a photovoltaic (PV) module comprising a photovoltaic element and one or more further layer elements, wherein at least one layer element is the layer element of said at least two layers. The article is most preferably a photovoltaic (PV) module.

The invention further provides a process for producing the layer element (LE) of the article comprising the step of

- adhering the first layer and the second layer together by extrusion or lamination.

The term "extrusion" has a well-known meaning in the polymer field to form a polymeric layer structure, like a polymer film. In polymer extrusion process the molten polymer material is fed via a die and solidified to form typically a layered structure, like film. Multiple layer structures can be produced e.g. by coextrusion process which means simultaneous extrusion of two or more, same or different polymer materials through the same die. Different extrusion processes and extrusion equipment are well described in the literature.

Similarly, the term "lamination" has a well-known meaning in the polymer field. In lamination process two or more premade layers, e.g. two polymeric layers, are typically adhered together in conventional lamination equipment using heat and pressure. The lamination processes and equipment are well described in the literature. The heating temperature is typically same or above the softening point of the major polymer component of at least one of the two layers to be adhered together, as well known to a skilled person.

The polymer (a), the polymer (b), the layer element (LE) thereof and the article, together with further details, preferred embodiments, ranges and properties thereof are described below and in claims, which preferred embodiments, ranges and properties can be in any combination and combined in any order.

Furthermore, the invention further provides the use of a protective back layer element comprising a polymer of propylene as the main polymeric component; and a front encapsulation layer element and a rear encapsulation layer element, which both encapsulation layer elements comprise as the main polymeric component in an amount of more than 50 wt%, preferably consist of, (a) a copolymer of ethylene which is selected from

(a1) a copolymer of ethylene which bears silane group(s) containing units; or
(a2) a copolymer of ethylene with one or more polar comonomer(s) selected from $(C_1-C_6)$-alkyl acrylate or $(C_1-C_6)$-alkyl $(C_1-C_6)$-alkylacrylate comonomer(s ), which copolymer (a2) bears silane group(s) containing units and which copolymer (a2) is different from the copolymer (a1); for increasing the resistance against Potential Induced Degradation (PID) or even preventing Potential Induced Degradation (PID) of a photovoltaic (PV) module comprising, in a given order, a protective front layer element, said front encapsulation layer element, a photovoltaic element, said rear encapsulation layer element and said protective back layer element. Preferably, the polymer of propylene of the protective back layer element is the (b) polymer of propylene (PP) of the invention as defined above, below or in claims. Preferably, the polymer (a) of the front encapsulation layer element and the rear encapsulation layer element is as defined above, below or in claims. More preferably, the polymer a) is a (a2) a copolymer of ethylene with one or more polar comonomer(s) selected from $(C_1-C_6)$-alkyl acrylate or $(C_1-C_6)$-alkyl $(C_1-C_6)$-alkylacrylate comonomer(s ), which copolymer (a2) bears silane group(s) containing units, as defined above, below or in claims. Without binding to any theory the polarity of polymer (a2) further improves the resistance against PID. Most preferably the polymer of propylene of the protective back layer element is the (b) polymer of propylene (PP) of the invention and the polymer (a), which is preferably the copolymer of ethylene (a2), of the front encapsulation layer element and the rear encapsulation layer element is as defined above, below or in claims.

**The polymer compositions of the first and second layer**

**The first layer of the layer element (LE):**

The first layer comprises, preferably consists of, a polymer composition comprising the polymer (a). Thereby, the first layer comprises more than 50 wt% of the copolymer of ethylene (a). The polymer composition comprising the polymer (a) is referred herein also shortly as "PE polymer composition" "PE composition" or "the composition of the first layer".

The silane group(s) containing units can be present as a comonomer of the polymer (a) or as a compound grafted chemically to the polymer (a). "Silane group(s) containing comonomer" means herein above, below or in claims that the silane group(s) containing units are present as a comonomer.

Accordingly, in case of silane group(s) containing units are incorporated to the polymer (a) as a comonomer, the silane group(s) containing units are copolymerized as comonomer with ethylene monomer during the polymerization process of polymer (a). In case the silane group(s) containing units are incorporated to the polymer by grafting, the silane group(s) containing units are reacted chemically (also called as grafting), with the polymer (a) after the polymerization of the polymer (a). The chemical reaction, i.e. grafting, is performed typically using a radical forming agent such as peroxide. Such chemical reaction may take place before or during the lamination process of the invention. In general, copolymerisation and grafting of the silane group(s) containing units to ethylene are well known techniques and well documented in the polymer field and within the skills of a skilled person.

It is also well known that the use of peroxide in the grafting embodiment decreases the melt flow rate (MFR) of an ethylene polymer due to a simultaneous crosslinking reaction. As a result, the grafting embodiment can bring limitation to the choice of the MFR of polymer (a) as a starting polymer, which choice of MFR can have an adverse impact on the quality of the polymer at the end use application. Furthermore, the by-products formed from peroxide during the grafting process can have an adverse impact on the use of the PE polymer composition at end use application. The copolymerisation of the silane group(s) containing comonomer into the polymer backbone provides more uniform incorporation of the units compared to grafting of the units. Moreover, compared to grafting, the copolymerisation does not require the addition of peroxide after the polymer is produced.

Thus preferably, the silane group(s) containing units are preferably present in polymer (a) as a comonomer. I.e. in case of polymer (a1) the silane group(s) containing units are copolymerised as a comonomer together with the ethylene monomer during the polymerisation process of the polymer (a1). And in case of the polymer (a2) the silane group(s) containing units are copolymerised as a comonomer together with the polar comonomer and ethylene monomer during the polymerisation process of polymer (a2).

Polymer (a2) thus contains two different comonomers, the silane group(s) containing comonomer and the polar comonomer as defined above, below or in claims.

The silane group(s) containing unit or, preferably, the silane group(s) containing comonomer of copolymer of ethylene (a1) or of copolymer of ethylene (a2), is preferably a hydrolysable unsaturated silane compound represented by the formula (I):

$$R^1SiR^2_qY_{3-q} \qquad (I)$$

wherein

$R^1$ is an ethylenically unsaturated hydrocarbyl, hydrocarbyloxy or (meth)acryloxy hydrocarbyl group,
each $R^2$ is independently an aliphatic saturated hydrocarbyl group,
Y which may be the same or different, is a hydrolysable organic group and q is 0, 1 or 2;

Further suitable silane group(s) containing comonomer is e.g. gamma-(meth)acryloxypropyl trimethoxysilane, gamma(meth)acryloxypropyl triethoxysilane, and vinyl triacetoxy silane, or combinations of two or more thereof.

One suitable subgroup of compound of formula (I) is an unsaturated silane compound or, preferably, comonomer of formula (II)

$$CH_2=CHSi(OA)_3 \qquad (II)$$

wherein each A is independently a hydrocarbyl group having 1-8 carbon atoms, suitably 1-4 carbon atoms.

The silane group(s) containing unit, or preferably, the comonomer, of the invention, is preferably the compound of formula (II) which is vinyl trimethoxysilane, vinyl bismethoxyethoxysilane, vinyl triethoxysilane, more preferably vinyl trimethoxysilane or vinyl triethoxysilane.

The amount (mol%) of the silane group(s) containing units present in the polymer (a), preferably present as comonomer, is preferably of 0.01 to 2.0 mol%, preferably 0.01 to 1.00 mol%, suitably from 0.05 to 0.80 mol%, suitably from 0.10 to 0.60 mol%, suitably from 0.10 to 0.50 mol%, when determined according to "Comonomer contents" as described below under "Determination Methods".

In one preferable embodiment A1, the polymer (a) is the copolymer of ethylene with silane group(s) containing comonomer (a1). In this embodiment A1, the polymer (a1) does not contain, i.e. is without, a polar comonomer as defined for polymer (a2). Preferably the silane group(s) containing comonomer is the sole comonomer present in the polymer (a1). Accordingly, the copolymer (a1) is preferably produced by copolymerising ethylene monomer in a high pressure polymerization process in the presence of silane group(s) containing comonomer using a radical initiator.

In said one preferable embodiment (A1), the polymer (a1) is preferably a copolymer of ethylene with silane group(s) containing comonomer according to formula (I), more preferably with silane group(s) containing comonomer according to formula (II), more preferably with silane group(s) containing comonomer according to formula (II) selected from vinyl trimethoxysilane, vinyl bismethoxyethoxysilane, vinyl triethoxysilane or vinyl trimethoxysilane comonomer, as defined above or in claims. Most preferably the polymer (a1) is a copolymer of ethylene with vinyl trimethoxysilane, vinyl bismethoxyethoxysilane, vinyl triethoxysilane or vinyl trimethoxysilane comonomer, preferably with vinyl trimethoxysilane or vinyl triethoxysilane comonomer, more preferably with vinyl trimethoxysilane.

In another preferable embodiment A2, the polymer (a) is a polymer of ethylene with one or more polar comonomer(s) selected from $(C_1-C_6)$-alkyl acrylate or $(C_1-C_6)$-alkyl $(C_1-C_6)$-alkylacrylate comonomer(s) (a2), which copolymer (a2) bears silane group(s) containing units. Preferably, the silane group(s) containing units are present as a comonomer as defined above, below or in claims. In this embodiment (A2) the polymer (a2) is thus preferably a copolymer of ethylene with one or more, preferably one, polar comonomer(s) selected from $(C_1-C_6)$-alkyl acrylate or $(C_1-C_6)$-alkyl $(C_1-C_6)$-alkylacrylate; and with silane group(s) containing comonomer.

Preferably, the polar comonomer of the polymer of ethylene (a2) is selected from one of $(C_1-C_6)$-alkyl acrylate comonomer, preferably from methyl acrylate, ethyl acrylate or butyl acrylate comonomer. More preferably, the polymer (a2) is a copolymer of ethylene with a polar comonomer selected from methyl acrylate, ethyl acrylate or butyl acrylate comonomer and bears silane group(s) containing units wherein the silane group(s) containing units are present as a comonomer as described above, below or in claims. I.e. the polymer (a2) is most preferably a copolymer of ethylene with a polar comonomer selected from methyl acrylate, ethyl acrylate or butyl acrylate comonomer and with silane group(s) containing comonomer.

The content of the polar comonomer present in the polymer (a2) is preferably of 0.5 to 30.0 mol%, 2.5 to 20.0 mol%, preferably of 4.5 to 18 mol%, preferably of 5.0 to 18.0 mol%, preferably of 6.0 to 18.0 mol%, preferably of 6.0 to 16.5 mol%, more preferably of 6.8 to 15.0 mol%, more preferably of 7.0 to 13.5 mol%, when measured according to "Comonomer contents" as described below under the "Determination methods".

In said another preferable embodiment (A2), the polymer (a2) is a copolymer of ethylene with the polar comonomer, as defined above, below or in claims, and with silane group(s) containing comonomer according to formula (I), more preferably with silane group(s) containing comonomer according to formula (II), more preferably with silane group(s) containing comonomer according to formula (II) selected from vinyl trimethoxysilane, vinyl bismethoxyethoxysilane, vinyl triethoxysilane or vinyl trimethoxysilane comonomer, as defined above or in claims. Preferably the polymer (a2) is a copolymer of ethylene with methyl acrylate, ethyl acrylate or butyl acrylate comonomer and with vinyl trimethoxysilane, vinyl bismethoxyethoxysilane, vinyl triethoxysilane or vinyl trimethoxysilane comonomer, preferably with vinyl trimethoxysilane or vinyl triethoxysilane comonomer. More preferably the polymer (a2) is a copolymer of ethylene with methyl acrylate comonomer and with vinyl trimethoxysilane, vinyl bismethoxyethoxysilane, vinyl triethoxysilane or vinyl trimethoxysilane comonomer, preferably with vinyl trimethoxysilane or vinyl triethoxysilane comonomer, more preferably with vinyl trimethoxysilane.

Accordingly, the polymer (a2) is most preferably a copolymer of ethylene with methyl acrylate comonomer together with silane group(s) containing comonomer as defined above, below or in claims, preferable a copolymer of ethylene with methyl acrylate comonomer and with vinyl trimethoxysilane or vinyl triethoxysilane comonomer, prefereably a copolymer copolymer of ethylene with methyl acrylate comonomer and with vinyl trimethoxysilane.

Without binding to any theory, for instance, methyl acrylate (MA) is the only acrylate which cannot go through the ester pyrolysis reaction, since does not have this reaction path. Therefore, the polymer (a2) with MA comonomer does not form any harmful free acid (acrylic acid) degradation products at high temperatures, whereby polymer (a2) of ethylene and methyl acrylate comonomer contribute to good quality and life cycle of the end article thereof. This is not the case e.g. with vinyl acetate units of EVA, since EVA forms harmful acetic acid degradation products at high temperatures. Moreover, the other acrylates like ethyl acrylate (EA) or butyl acrylate (BA) can go through the ester pyrolysis reaction, and if degrade, would form volatile olefinic by-products.

The polymer PE composition, which comprises the polymer (a) and present in the first layer, enables, if desired, to decrease the MFR of the polymer (a1) or (a2) compared to prior art and thus offers higher resistance to flow during the production of the first layer and the layer element (LE) of the invention. As a result, the preferable MFR can further contribute, if desired, to the quality of the layer element (LE), and to article, like PV module, comprising the layer element (LE).

The melt flow rate, $MFR_2$, of the PE composition, preferably of polymer (a), of the first layer, is preferably less than 20 g/10 min, preferably less than 15 g/10 min, preferably from 0.1 to 13 g/10 min, preferably from 0.2 to 10 g/10 min, preferably from 0.3 to 8 g/10 min, more preferably from 0.4 to 6, g/10 min (according to ISO 1133 at 190 °C and at a load of 2.16 kg).

The PE composition, preferably of polymer (a), of the first layer has preferably a Shear thinning index, $SHI_{0.05/300}$, of 30.0 to 100.0, preferably of 40.0 to 80.0, when measured according to "Rheological properties: Dynamic Shear Measurements (frequency sweep measurements)" as described below under "Determination Methods".

The preferable SHI range further contributes to the advantageous rheological properties of the PE polymer composition of the first layer.

Accordingly, the combination of the preferable MFR range and the preferable SHI range of the PE polymer composition, which comprises the polymer (a) and present in the first layer, further contributes to the quality of the first layer and the layer element (LE) of the invention. As a result, the preferable MFR can further contribute, if desired, to the quality of the layer element (LE), and to article, like PV module, comprising the layer element (LE).

The PE composition, preferably the polymer (a), preferably has a melting temperature of 120°C or less, preferably 110°C or less, more preferably 100°C or less and most preferably 95°C or less, when measured according to ASTM D3418 as described under "Determination Methods". Preferably the melting temperature of the PE composition, more preferably the polymer (a) is 70°C or more, more preferably 75°C or more, even more preferably 78°C or more, when measured as described below under "Determination Methods". The preferable melting temperature is beneficial for instance for a lamination process, since the time of the melting/softening step can be reduced.

Typically, and preferably the density of the PE composition, preferably of the polymer of ethylene (a), of the first layer is higher than 860 kg/m3. Preferably the density is not higher than 970 kg/m3, and preferably is from 920 to 960 kg/m3, according to ISO 1872-2 as described below under "Determination Methods".

Preferred polymer (a) is a copolymer of ethylene (a1) with vinyl trimethoxysilane comonomer or a copolymer of ethylene (a2) with methylacrylate comonomer and with vinyl trimethoxysilane comonomer. The most preferred polymer (a) is a copolymer of ethylene (a2) with methylacrylate comonomer and with vinyl trimethoxysilane comonomer.

The polymer (a) of the PE composition can be e.g. commercially available or can be prepared according to or analogously to known polymerization processes described in the chemical literature.

In a preferable embodiment the polymer (a), i.e. polymer (a1) or (a2), is produced by polymerising ethylene suitably with silane group(s) containing comonomer (= silane group(s) containing units present as comonomer) as defined above, and in case of polymer (a2) also with the polar comonomer(s), in a high pressure (HP) process using free radical polymerization in the presence of one or more initiator(s) and optionally using a chain transfer agent (CTA) to control the MFR of the polymer. The HP reactor can be e.g. a well-known tubular or autoclave reactor or a mixture thereof, suitably a tubular reactor. The high pressure (HP) polymerisation and the adjustment of process conditions for further tailoring the other properties of the polymer depending on the desired end application are well known and described in the literature, and can readily be used by a skilled person. Suitable polymerisation temperatures range up to 400 °C, suitably from 80 to 350°C and pressure from 70 MPa, suitably 100 to 400 MPa, suitably from 100 to 350 MPa. The high pressure polymerization is generally performed at pressures of 100 to 400 MPa and at temperatures of 80 to 350 °C. Such processes are well known and well documented in the literature and will be further described later below.

The incorporation of the comonomer(s), when present, including the preferred form of silane group(s) containing units as comonomer, to the ethylene monomer and the control of the comonomer feed to obtain the desired final content of said comonomer(s) can be carried out in a well-known manner and is within the skills of a skilled person.

Further details of the production of ethylene (co)polymers by high pressure radical polymerization can be found i.a. in the Encyclopedia of Polymer Science and Engineering, Vol. 6 (1986), pp 383-410 and Encyclopedia of Materials: Science and Technology, 2001 Elsevier Science Ltd.: "Polyethylene: High-pressure, R.Klimesch, D.Littmann and F.-O. Mähling pp. 7181-7184.

Such HP polymerisation results in a so called low density polymer of ethylene (LDPE), herein to polymer (a1) or polymer (a2). The term LDPE has a well-known meaning in the polymer field and describes the nature of polyethylene produced in HP, i.e. the typical features, such as different branching architecture, to distinguish the LDPE from PE produced in the presence of an olefin polymerisation catalyst (also known as a coordination catalyst). Although the term LDPE is an abbreviation for low density polyethylene, the term is understood not to limit the density range, but covers the LDPE-like HP polyethylenes with low, medium and higher densities.

Below, the amounts "Based on the (total) amount (100 wt%) of the PE polymer composition of the invention" means that the amounts of the components present in the PE composition of the first layer total to 100 wt%.

In one embodiment of the PE composition of the invention of the first layer of the layer element (LE) suitably comprises additive(s) which are other than filler, pigment, carbon black or flame retardant which terms have a well-known meaning in the prior art. Then the PE composition, comprises, preferably consists of, based on the amount (100 wt%) of the PE composition,

- 90 to 99.9999 wt% of the polymer (a); and
- 0.0001 to 10 wt% of the additives, preferably 0.0001 and 5.0 wt%, like 0.0001 and 2.5 wt%, of the additives.

The optional additives are e.g. conventional additives suitable for the desired end application and within the skills of a skilled person, including without limiting to, preferably at least antioxidant(s), UV light stabilizer(s) and/or UV light absorbers, and may also include metal deactivator(s), clarifier(s), brightener(s), acid scavenger(s), as well as slip agent(s) etc. Each additive can be used e.g. in conventional amounts, the total amount of additives present in the PE composition (C) being preferably as defined above. Such additives are generally commercially available and are described, for example, in "Plastic Additives Handbook", 5th edition, 2001 of Hans Zweifel.

In another embodiment of the PE composition of the invention of the first layer of the layer element (LE) comprises in addition to the suitable additives as defined above also one or more of filler, pigment, carbon black or flame retardant. Then the composition of the first layer comprises, preferably consists of, based on the total amount (100wt%) of the PE composition,

- 30 to 90 wt%, suitably 40 to 70 wt%, of the polymer (a);
- 0.0001 to 10 wt% of the additives, preferably 0.0001 and 5.0 wt%, like 0.0001 and 2.5 wt%, of the additives; and
- up to 70 wt%, suitably up to 30 wt%, preferably up to 5 wt%, of the one or more of filler, pigment, carbon black or flame retardant.

Optional fillers, pigments, carbon black or flame retardants, are typically conventional and commercially available. Suitable optional fillers and pigments are as defined herein in context of the first layer to fillers, pigments. Optional carbon black can be any conventional product suitable for the first layer. Optional flame retardants can be as defined below for the second layer or in claims or e.g. magensiumhydroxide, ammounium polyphosphate etc.

In the preferred embodiment the composition of the first layer comprises, preferably consists of,

- 90 to 99.9999 wt% of the polymer (a);
- 0.0001 to 10 wt% of additives and optionally 0 to 20 wt% of one or more of filler or pigment; preferably 0.0001 to 2.5 wt% of additives and optionally 0 to 15 wt% of a pigment.

In a preferable embodiment the PE composition consists of the polymer (a) as the only polymeric component(s). "Polymeric component(s)" exclude herein any carrier polymer(s) of optional additive or filler, pigment, carbon black or flame retardant, e.g. carrier polymer(s) used in master batch(es) of additive or, respectively, filler, pigment, carbon black or flame retardant optionally present in the composition of the first layer of the layer element (LE). Such optional carrier polymer(s) are calculated to the amount of the respective additive or, respectively, pigment or filler based on the amount (100 wt%) of the composition of the first layer of the layer element (LE).

Preferably the first layer of the layer element (LE) consists of the PE composition comprising the polymer (a) as defined above, below or in claims.

The first layer of the layer element (LE), preferably the composition of the first layer, more preferably the polymer (a), is preferably, most preferably, not crosslinked using peroxide.

However, if desired, depending on the end application, the composition of the first layer of the layer element (LE) can be crosslinked via silane group(s) containing units using a silanol condensation catalyst (SCC), which is preferably selected from the group of carboxylates of tin, zinc, iron, lead or cobalt or aromatic organic sulphonic acids, before or during the lamination process of the invention. Such SCCs are for instance commercially available.

It is to be understood that the SCC as defined above are those conventionally supplied for the purpose of crosslinking.

The silanol condensation catalyst (SCC), which can optionally be present in the composition of the first layer of the layer element (LE), is more preferably selected from the group C of carboxylates of metals, such as tin, zinc, iron, lead and cobalt; from a titanium compound bearing a group hydrolysable to a Brönsted acid (preferably as described in WO 2011/160964 of Borealis, included herein as reference), from organic bases; from inorganic acids; and from organic acids; suitably from carboxylates of metals, such as tin, zinc, iron, lead and cobalt, from titanium compound bearing a group hydrolysable to a Brönsted acid as defined above or from organic acids, suitably from dibutyl tin dilaurate (DBTL), dioctyl tin dilaurate (DOTL), particularly DOTL; titanium compound bearing a group hydrolysable to a Brönsted acid as defined above; or an aromatic organic sulphonic acid, which is suitably an organic sulphonic acid which comprises the structural element:

$$Ar(SO_3H)_x \qquad (III)$$

wherein Ar is an aryl group which may be substituted or non- substituted, and if substituted, then suitably with at least one hydrocarbyl group up to 50 carbon atoms, and x is at least 1; or a precursor of the sulphonic acid of formula (III) including an acid anhydride thereof or a sulphonic acid of formula (III) that has been provided with a hydrolysable protective group(s), e.g. an acetyl group that is removable by hydrolysis. Such organic sulphonic acids are described e.g. in EP736065, or alternatively, in EP1309631 and EP1309632.

In a preferable embodiment no silane condensation catalyst (SCC), which is selected from the SCC group of tin-organic catalysts or aromatic organic sulphonic acids, is present in composition of the first layer of the layer element (LE). In a further preferable embodiment no peroxide or silane condensation catalyst (SCC), as defined above, is present in composition of the first layer of the layer element (LE). As already mentioned, with the present preferable PE composition of the first layer, crosslinking of the first layer of the layer element (LE) can be avoided which contributes to achieve the good quality of the layer element (LE).

The amount of the optional crosslinking agent (SCC), if present, is preferably of 0 to 0.1 mol/kg, like 0.00001 to 0.1, preferably of 0.0001 to 0.01, more preferably 0.0002 to 0.005, more preferably of 0.0005 to 0.005, mol/kg polymer of ethylene (a). As said preferably no crosslinking agent (SCC) is present in the layer element (LE).

**Second layer of the layer element (LE)**

The second layer of the layer element (LE) comprises a polymer composition comprising the PP polymer (b).

The polymer composition comprising the PP polymer (b) can be referred herein also as "PP composition", "PP polymer composition" or "composition of the second layer".

The polymer of propylene (PP) (b) of the second layer can also be a mixture of two or more different PP polymers.

The PP polymer can be a homopolymer or copolymer of propylene.

Preferably the PP polymer is at least a copolymer of propylene. More preferably the PP polymer is selected from a heterophasic copolymer of propylene (iPP) which comprises, preferably consists of,

a polypropylene matrix component and
an elastomeric propylene copolymer component which is dispersed in said polypropylene matrix; or a mixture of two or more, e.g. two such heterophasic copolymers of propylene (iPP) which are different.

"Heterophasic copolymer of propylene (iPP)" is referred herein also as "PP copolymer".

Moreover, said PP copolymer can comprise, preferably consist of, one or more PP copolymer components which are different.

In one preferable embodiment the PP copolymer as at least one polymer of propylene (PP) (b) is selected from a heterophasic copolymer of propylene (iPP) which comprises a heterophasic copolymer of propylene (A) which comprises, preferably consists of,

- a polypropylene matrix component (a1) and
- an elastomeric propylene copolymer component (a2) which is dispersed in said polypropylene matrix (a1);

and wherein the heterophasic copolymer of propylene (A) has a Melting temperature (Tm) (DSC) of at least 145°C, when measured as described in the specification under Determination methods, and a Vicat softening temperature (Vicat A) of at least 90°C (according to ASTM D 1525, method A, 50°C/h, 10N).

The PP polymer (b) preferably comprises at least one heterophasic copolymer of propylene (iPP) which preferably consists of the heterophasic copolymer of propylene (A).

The heterophasic copolymer of propylene (A) is referred herein also as "PP copolymer (A)".

PP copolymer is preferably PP copolymer (A). The PP composition preferably comprises one or two or more different PP copolymers (A). In one embodiment the PP composition comprises two or more PP copolymer (A). In another embodiment the PP composition comprises one PP copolymer (A).

The "polypropylene matrix component (a1)" is referred herein also as "matrix component (a1)". The "elastomeric propylene copolymer component (a2)" is referred herein also as "elastomeric component (a2)".

Generally, a "heterophasic copolymer of propylene" (as used herein in connection to PP copolymer or preferable PP copolymer (A)) is a propylene copolymer comprising a propylene homo polymer or propylene random copolymer matrix component (1) and an elastomeric copolymer component (2) of propylene with one or more of ethylene and/or $C_4$-$C_8$ alpha olefin comonomers, wherein the elastomeric (amorphous) copolymer component (2) is (finely) dispersed in said propylene homo or random copolymer matrix polymer (1).

Propylene random copolymer as the matrix component (1) is preferably a copolymer of propylene with one or more of ethylene and/or $C_4$-$C_8$ alpha olefin comonomers. The XCS fraction of PP copolymer (or preferable PP copolymer (A)) is regarded herein as the elastomeric component (or preferable elastomeric component (a2)), since the amount of XCS fraction in the matrix component is conventionally markedly lower. For instance, in case the matrix component (or preferable matrix component (a1)) is a homopolymer of propylene, then the amount of the xylene cold soluble (XCS) fraction (amorphous fraction) (wt%) of the heterophasic copolymer of propylene is understood in this application also as the amount of the elastomeric propylene copolymer component present in the PP copolymer (or preferable PP copolymer (A)).

Preferably the polypropylene matrix component of the PP copolymer, preferably PP copolymer (A), is a homopolymer of propylene.

The total comonomer content of the copolymer of propylene, preferably of the PP copolymer, is preferably of 0.5 to 20, preferably of 1.0 to 20, wt%, when measured as described in the specification under Determination methods, preferably the comonomer(s) is selected from ethylene and/or $C_4$-$C_8$ alpha olefin comonomers, more preferably from ethylene.

The PP copolymer is most preferably a PP copolymer (A).

The melting temperature, Tm, of PP copolymer (A) is preferably of 158 to 170, preferably of 160 to 170,°C, when measured as described in the specification under Determination methods.

The Vicat softening temperature (Vicat A) of PP copolymer (A) is preferably of at least 100, preferably of 100 to 165, preferably of 110 to 165, preferably 110 to 160, °C.

Preferably, the polypropylene matrix (a1) of the PP copolymer (A) is a homopolymer of propylene.

Even more preferably the heterophasic copolymer of propylene (A) has one or more, in any order, preferably all, of the following further properties:

- MFR$_2$ of 0.2 to 20, preferably 0.2 to 15.0, preferably of 0.5 to 15, g/10 min when measured according to ISO 1133 (at 230°C and 2.16 kg load),
- Xylene cold soluble (XCS) fraction in amount of 3 to 40, preferably of 5 to 37, wt%, when measured as described in specification under Determination methods,
- Comonomer content of 0.5 to 20, preferably of 1.0 to 20, wt%, when measured as described in the specification under Determination methods, preferably the comonomer(s) is selected from ethylene and/or C$_4$-C$_8$ alpha olefin comonomers, more preferably from ethylene,
- Tensile modulus of at least 700, preferably of 750 to 2500, preferably of 750 to 2000, MPa, when measured according to ISO178 as described in the specification under Determination methods, and/or
- Density of 900 to 910 kg/m$^3$, when measured as described in the specification under Determination methods.

The composition of the second layer of the invention preferably comprises, preferably consists of:

(i) more than 25 wt%, preferably 30 to 98.8 wt%, preferably 30 to 98.5 wt%, of a PP polymer (b),
(ii) 0.2 to 5 wt%, preferably of 0.5 to 5 wt%, of an additives,
(iii) 0 to 60 wt%, preferably 0 to 50 wt%, of one or more selected from filler (iiia), pigment (iiib) and flame retardant (iiic) which are different from additives (ii),
(iv) 0 to 50 wt% of further polymer component(s) which are different from PP polymer (b)

based on the total amount (100 wt%) of the PP composition.

"Based on the total amount (100 wt%) of the PP composition of the invention" means that the amounts of the components present in the PP composition of the second layer total to 100wt%.

Accordingly, herein filler (iiia), pigment (iiib) and flame retardant (iiic) are not understood nor defined as the additives (ii).

Preferably the PP composition preferably comprises at least one or both of component (iii) or (iv).

The optional filler (iiia), if present, is preferably inorganic filler. The particle size and/or aspect ratio of the filler (iii) can vary as well-known by a skilled person. Preferably, the filler (iii) is selected from one or more of wollastonite, talc or glass fiber. Such filler products are commercial products with varying particle size and/or aspect ratio and can be chosen by a skilled person depending on the desired end article and end application. The filler (iiia) can be e.g. conventional and commercially available. The amount of the filler (iiia), if present, is preferably 1 to 30, preferably 2 to 25, wt% based on the total amount (100 wt%) of the PP composition.

The optional pigment (iiib), if present, is preferably white pigment. White pigment is preferably TiO$_2$. Such pigments are well known and e.g. available as commercial TiO$_2$ pigment, also referred herein as TiO$_2$. Any carrier medium, e.g. carrier polymer, is calculated to the amount of the pigment. The amount of the pigment, if present, is preferably 2 to 45, preferably 5 to 45, preferably 10 to 45, wt% based on the total amount (100 wt%) of the PP composition.

The optional flame retardant (iiic), if present, can be e.g. any commercial flame retardant product, preferably a flame retardant comprising inorganic phosphor. The amount of the flame retardant (iiic), if present, is preferably of 1 to 20, preferably 2 to 15, more preferably 3 to 12, wt% based on the amount (100wt%) of the PP composition of the invention.

In one embodiment the PP composition comprises at least the filler (iiib).

The optional further polymer component(s) (iv) can be any polymer other than PP polymer, preferably a polyolefin based polymer. Typical examples of further polymer component(s) (iv) is one or both of a plastomer (iva) or functionalised polymer (ivb) which both have a well-known meaning.

The optional plastomer (iva), if present, is preferably a copolymer of ethylene with at least one C3 to C10 alpha-olefin. The plastomer (iva), if present, has preferably one or all, preferably all, of the below properties

- a density of 860 to 915, preferably 860 to 910, kg/m$^3$,
- MFR$_2$ of 0.1 to 50, preferably 0.2 to 40 g/10min (190°C, 2. 16kg), and/or
- the alpha-olefin comonomer is octene.

The optional plastomer (iva), if present, is preferably produced using a metallocene catalyst, which term has a well-known meaning in the prior art. The suitable plastomers (iva) are commercially available, e.g. plastomer products under tradename QUEO™, supplied by Borealis, or Engage™ , supplied by ExxonMobil, Lucene supplied by LG, or Tafmer supplied by Mitsui. If present, then the amount of the optional plastomer (v) is lower than the amount of PP polymer (b).

The optional functionalised polymer (ivb), if present, is a polymer which is functionalised e.g. by grafting. For instance, polar functional groups, such as maleic anhydride (MAH), can be grafted to a polyolefin to form functional polymers (ivb) thereof. The PP polymer (b) is different from optional functionalised polymer (ivb). The PP polymer (b) of the invention as defined above, below or in claims, is without grafted functional units. I.e. the term PP polymer (b) of the invention excludes the PP polymer grafted with functional groups. The amount of the optional functionalised polymer (ivb), if present, is preferably of 3 to 30, preferably 3 to 20, preferably 3 to 18, more preferably 4 to 15, wt% based on the amount (100wt%) of the PP composition of the invention. If present, then the amount of the optional functionalised polymer(s) (ivb) is less than the amount of PP polymer (b).

In one embodiment the PP composition comprises at least one of components (iii) or (iv), suitably both component (iii) and component (iv), suitably one, more or all of component (iiia), component (iva) or component (ivb). In one embodiment the PP composition comprises at least component (iiib) and component (iva).

The amount of the PP polymer (b) is equal or higher than the amount of the optional palstomer (iva) or optional functionalised polymer (ivb

The PP composition of the invention comprises additives (ii). Herein the term additives (ii) exclude the optional filler (iiia), optional pigment (iiib) and optional flame retardant ((iiic). Such additives (ii) are preferably conventional and commercially available, including without limiting to, UV stabilisers, antioxidants, nucleating agents, clarifiers, brighteners, acid scavengers, as well as slip agents, processing aids etc. Such additives are generally commercially available and are described, for example, in "Plastic Additives Handbook", 5th edition, 2001 of Hans Zweifel.

Each additive (ii) can be used e.g. in conventional amounts. The suitable additives (ii) and the amounts thereof for the second layer of the layer element (LE) can be chosen by a skilled person depending on the desired article and the end use thereof.

Preferably, the additives (ii) are selected at least from (iia) UV stabiliser(s) comprising hindered amine compound and (iib) antioxidant comprising a dialkyl amine compound. More preferably the additives (ii) are selected at least from (iia) UV stabiliser(s) comprising hindered amine compound and (iib) antioxidant comprising a dialkyl amine compound, and wherein the additives (ii) are without phenolic unit(s). The expression "the additives (ii) are without phenolic unit(s)" means herein that any additive compound including UV stabiliser(s) (iia) and antioxidant (iib) present in the PP composition bears no phenolic units. Preferably the composition does not comprise any components, like additives (ii), with phenolic units.

Any optional carrier polymers of additives (ii), of optional filler (iiia), of optional pigment (iiib) and of optional flame retardant ((iiic), e.g. master batches of components (ii), (iiia), (iiib) or, respectively, (iiic), together with the carrier polymer, are calculated to the amount of the respective component (ii), (iiia), (iiib) or (iiic) based on the amount (100 %) of the PP composition of the invention.

The PP composition of the invention preferably has an $MFR_2$ of 1.0 to 25.0, preferably of 2.0 to 20, preferably of 3 to 15, g/10 min, when measured according to ISO 1133 (at 230 °C with 2.16 kg load) as defined below under the Determination methods. The polymer composition has more preferably $MFR_2$ of 3 to 10 g/10 min.

The PP composition of the invention preferably has a Xylene cold soluble (XCS) content in amount of 5 to 40, preferably 5 to 37%, when measured as defined below under the Determination methods.

The PP composition of the invention preferably has a Vicat softening temperature (Vicat A) of 100 to 165, more preferably of 110 to 160,°C, when measured as described below under Determination methods. The Vicat A of the PP composition is more preferably of 120 to 160°C.

The PP composition of the invention preferably has a Tensile modulus of at least 800, preferably of 800 to 3000, preferably of 850 to 2700, MPa, when measured in machine direction (MD) from 200 $\mu$m monolayer cast film sample as defined below under the Determination methods. Said Tensile modulus of the PP composition is preferably of 850 to 2300 MPa.

The PP composition of the invention preferably has a Tensile strength of 20 to 40, preferably of 23 to 37, preferably of 25 to 33, MPa, when measured in machine direction (MD) from 200 $\mu$m monolayer cast film sample as defined below under the Determination methods.

PP polymer can be commercially available grade or can be produced e.g. by conventional polymerisation processes and process conditions using e.g. the conventional catalyst system known in the literature.

One feasible polymerisation process including the conditions and catalyst system is generally described below for the PP copolymer, i.e. for the heterophasic copolymer of propylene (iPP), and naturally applies also for the preferable heterophasic copolymer of propylene (A) of the PP composition. It is evident that the below description can be applied to a homopolymer or a random copolymer of polypropylene, as well, whereby said polymers can be polymerised e.g. in optional prepolymerisation reactor following first reactor (preferably loop reactor) and then second reactor (preferably first gas phase reactor) using preferably the conditions as described below.

The polypropylene matrix component of the PP copolymer may be a unimodal or a multimodal random copolymer or homopolymer of propylene which both have a well-known meaning. Multimodal random copolymer or homopolymer of propylene means herein that it has at least two polymer fractions which are different e.g. with one or two of the following properties: 1) weight average molecular weight or 2) MFR. In case of random copolymer of propylene as the matrix component, the copolymer can also be multimodal with respect to 3) comonomer content, optionally in combination with any or both of the above differences 1) and 2).

The matrix component of the PP copolymer can be a homopolymer or random copolymer of propylene. It is preferred that the matrix component of the PP copolymer is a homopolymer of propylene.

Accordingly, it is preferred that all the comonomers as defined above, which are present in the PP copolymer, originate from the elastomeric propylene copolymer component.

It is preferred that the PP copolymer consists of the matrix component and the elastomeric component. The PP copolymer may optionally comprise a prepolymer fraction, as well known in the polymer field. In such case the amount of the prepolymer is calculated to the amount of the matrix component.

As said, the iPP copolymer can be commercially available grade or can be produced e.g. by conventional polymerisation processes.

As to polymerisation of the heterophasic copolymer of propylene, the individual components (matrix and elastomeric components) of PP copolymer can be produced separately and blended mechanically by mixing in a mixer or extruder. However it is preferred that the PP copolymer comprising the matrix component and the elastomeric component are produced in a sequential process, using reactors in serial configuration and operating at different reaction conditions. Consequently, each fraction prepared in a specific reactor can have its own molecular weight distribution, MFR and/or comonomer content distribution.

The PP copolymer according to this invention is preferably produced in a sequential polymerisation process, i.e. in a multistage process, known in the art, wherein the matrix component is produced at least in one slurry reactor, preferably at least in a slurry reactor, and optionally, and preferably in a subsequent gas phase reactor, and subsequently the elastomeric component is produced at least in one, i.e. one or two, gas phase reactor(s) (gpr), preferably in one gpr.

Accordingly it is preferred that the PP copolymer is produced in a sequential polymerisation process comprising the steps of

(a) polymerising propylene and optionally at least one ethylene and/or $C_4$ to $C_{12}$ $\alpha$-olefin, preferably propylene as the only monomer, in the presence of a catalyst in a first reactor (R1),

(b) transferring the reaction mixture of the polymerised first polypropylene, preferably propylene homopolymer, fraction together with the catalyst, into a second reactor (R2),

(c) polymerising in the second reactor (R2) and in the presence of said first polypropylene polymer, propylene and optionally at least one ethylene and/or $C_4$ to $C_{12}$ $\alpha$-olefin, preferably propylene as the only monomer, in obtaining thereby the second polypropylene fraction, preferably said second polypropylene fraction is a second propylene homopolymer, whereby said first polypropylene fraction and said second polypropylene fraction form the matrix component of the PP copolymer,

(d) transferring the reaction mixture of the polymerised matrix component of step (c) into a third reactor (R3),

(e) polymerising in the third reactor (R3) and in the presence of the matrix component obtained in step (c), propylene and at least one ethylene and/or $C_4$ to $C_{12}$ a-olefin obtaining thereby the elastomeric component of PP copolymer, wherein the elastomeric propylene copolymer component is dispersed in said matrix component.

Optionally the elastomeric component of the PP copolymer can be produced in two reactors, whereby after above step (e), the process further comprises the following steps:

(f) transferring the PP product of step (e) in which the first elastomeric propylene copolymer fraction polymerised in the third reactor (R3) is dispersed in said matrix component in a fourth reactor (R4), and

(g) polymerising in the fourth reactor (R4) and in the presence of the mixture obtained in step (e) propylene and at least one ethylene and/or $C_4$ to $C_{12}$ $\alpha$-olefin obtaining thereby the second elastomeric propylene copolymer fraction, whereby the first elastomeric propylene copolymer fraction of step (e) and the second elastomeric propylene copolymer fraction of step (g) are both dispersed in the matrix component of step (c) and together form the PP copolymer.

Preferably between the second reactor (R2) and the third reactor (R3) the monomers are flashed out.

The term "sequential polymerisation process" indicates that the PP copolymer is produced in at least two, like three, reactors connected in series. Accordingly the present process comprises at least a first reactor (R1) and a second reactor (R2), more preferably a first reactor (R1), a second reactor (R2), a third reactor (R3) and optionally a fourth reactor (R4). The term "polymerisation reactor" shall indicate one of the main polymerisation steps. Thus in case the process consists of four polymerisation reactors, this definition does not exclude the option that the overall process comprises for instance a prepolymerisation step in a prepolymerisation reactor. The term "consist of" is only a closing formulation in view of the main polymerisation reactors.

Any prepolymer fraction is counted into the amount of the first polypropylene fraction.

The first reactor (R1) is preferably a slurry reactor (SR) and can be any continuous or simple stirred batch tank reactor or loop reactor operating in bulk or slurry. Bulk means a polymerisation in a reaction medium that comprises of at least 60 % (w/w) monomer. According to the present invention the slurry reactor (SR) is preferably a (bulk) loop reactor (LR).

The second reactor (R2), the third reactor (R3) and the optional fourth reactor (R4) are preferably gas phase reactors (GPR). Such gas phase reactors (GPR) can be any mechanically mixed or fluid bed reactors. Preferably the gas phase reactors (GPR) comprise a mechanically agitated fluid bed reactor with gas velocities of at least 0.2 m/sec. Thus it is appreciated that the gas phase reactor is a fluidized bed type reactor preferably with a mechanical stirrer.

Thus in a preferred embodiment the first reactor (R1) is a slurry reactor (SR), like a loop reactor (LR), whereas the second reactor (R2), the third reactor (R3) and the optional fourth reactor (R4) are gas phase reactors (GPR). Accordingly for the instant process at least three, namely a slurry reactor (SR), like a loop reactor (LR), a first gas phase reactor (GPR-1), a second gas phase reactor (GPR-2) and an optional a third gas phase reactor (GPR-3) connected in series are used. In case of a prepolymerisation step a pre-polymerisation reactor is placed prior to the slurry reactor (SR).

A preferred multistage process is a "loop-gas phase"-process, such as developed by Borealis A/S, Denmark (known as BORSTAR® technology) described e.g. in patent literature, such as in EP 0 887 379, WO 92/12182 WO 2004/000899, WO 2004/111095, WO 99/24478, WO 99/24479 or in WO 00/68315.

A further suitable slurry-gas phase process is the Spheripol® process of LyondellBasell.

Preferably, in the instant process for producing the PP copolymer as defined above the conditions for the first reactor (R1), i.e. the slurry reactor (SR), like a loop reactor (LR), of step (a) may be as follows:

- the temperature is within the range of 50 °C to 110 °C, preferably between 60 °C and 100 °C, more preferably between 68 and 95 °C,
- the pressure is within the range of 20 bar to 80 bar, preferably between 40 bar to 70 bar,
- hydrogen can be added for controlling the molar mass in a manner known per se.

Subsequently, the reaction mixture from step (a) is transferred to the second reactor (R2), i.e. gas phase reactor (GPR-1), i.e. to step (c), whereby the conditions in step (c) are preferably as follows:

- the temperature is within the range of 50 °C to 130 °C, preferably between 60 °C and 100 °C,
- the pressure is within the range of 5 bar to 50 bar, preferably between 15 bar to 35 bar,
- hydrogen can be added for controlling the molar mass in a manner known per se.

The condition in the second gas phase reactor (GPR-2) and in the optional third gas phase reactor (GPR-3) are similar to the second reactor (R2) (= first gas phase reactor (GPR-1).

The residence time can vary in the three reactor zones.

In one embodiment of the process for producing the matrix component of the PP copolymer, the residence time in bulk reactor, e.g. loop, is in the range 0.1 to 2.5 hours, e.g. 0.15 to 1.5 hours and the residence time in gas phase reactor will generally be 0.2 to 6.0 hours, like 0.5 to 4.0 hours.

If desired, the polymerisation may be effected in a known manner under supercritical conditions in the first reactor (R1), i.e. in the slurry reactor (SR), like in the loop reactor (LR), and/or as a condensed mode in the gas phase reactors (GPR).

Preferably the process comprises also a prepolymerisation with the catalyst system, as described in detail below, comprising a Ziegler-Natta procatalyst, an external donor and optionally a cocatalyst.

In a preferred embodiment, the prepolymerisation is conducted as bulk slurry polymerisation in liquid propylene, i.e. the liquid phase mainly comprises propylene, with minor amount of other reactants and optionally inert components dissolved therein.

The prepolymerisation reaction is typically conducted at a temperature of 10 to 60 °C, preferably from 15 to 50 °C, and more preferably from 20 to 45 °C.

The pressure in the prepolymerisation reactor is not critical but must be sufficiently high to maintain the reaction mixture in liquid phase. Thus, the pressure may be from 20 to 100 bar, for example 30 to 70 bar.

The catalyst components are preferably all introduced to the prepolymerisation step. However, where the solid catalyst component (i) and the cocatalyst (ii) can be fed separately it is possible that only a part of the cocatalyst is introduced into the prepolymerisation stage and the remaining part into subsequent polymerisation stages. Also in such cases it is necessary to introduce so much cocatalyst into the prepolymerisation stage that a sufficient polymerisation reaction is obtained therein.

It is possible to add other components also to the prepolymerisation stage. Thus, hydrogen may be added into the prepolymerisation stage to control the molecular weight of the prepolymer as is known in the art. Further, antistatic additive may be used to prevent the particles from adhering to each other or to the walls of the reactor.

The precise control of the prepolymerisation conditions and reaction parameters is within the skills of the skilled person.

After the PP copolymer has been removed from the last polymerisation stage, it is preferably subjected to process steps for removing the residual hydrocarbons from the polymer. Such processes are well known in the art and can include pressure reduction steps, purging steps, stripping steps, extraction steps and so on. Also combinations of different steps are possible. After the removal of residual hydrocarbons the PP copolymer is preferably mixed with additives as it is well known in the art. Such additives are described above under the PP composition of the invention. The polymer particles are then extruded to pellets as it is known in the art. Preferably co-rotating twin screw extruder is used for the extrusion step. Such extruders are manufactured, for instance, by Coperion (Werner & Pfleiderer) and Japan Steel Works.

The PP copolymer of the invention is preferably produced by polymerisation using any suitable Ziegler-Natta type. Typical suitable Ziegler-Natta type catalyst is stereospecific, solid high yield Ziegler-Natta catalyst component comprising as essential components Mg, Ti and Cl. In addition to the solid catalyst a cocatalyst(s) as well external donor(s) are typically used in polymerisation process.

Components of catalyst may be supported on a particulate support, such as inorganic oxide, like silica or alumina, or, usually, the magnesium halide may form the solid support. It is also possible that catalysts components are not supported on an external support, but catalyst is prepared by emulsion-solidification method or by precipitation method.

Alternatively the PP copolymer of the invention can be produced using a modified catalyst system as described below.

More preferably, a vinyl compound of the formula (I) is used for the modification of the catalyst:

$$CH_2=CH-CHR^1R^2 \qquad (IV)$$

wherein $R^1$ and $R^2$ together form a 5- or 6-membered saturated, unsaturated or aromatic ring, optionally containing substituents, or independently represent an alkyl group comprising 1 to 4 carbon atoms, whereby in case $R^1$ and $R^2$ form an aromatic ring, the hydrogen atom of the $-CHR^1R^2$ moiety is not present.

More preferably, the vinyl compound (IV) is selected from: vinyl cycloalkane, preferably vinyl cyclohexane (VCH), vinyl cyclopentane, 3-methyl-1-butene polymer and vinyl-2-methyl cyclohexane polymer. Most preferably the vinyl compound (IV) is vinyl cyclohexane (VCH) polymer.

The solid catalyst usually also comprises an electron donor (internal electron donor) and optionally aluminium. Suitable internal electron donors are, among others, esters of carboxylic acids or dicarboxylic acids, like phthalates, maleates, benzoates, citraconates, and succinates, 1,3-diethers or oxygen or nitrogen containing silicon compounds. In addition mixtures of donors can be used.

The cocatalyst typically comprises an aluminium alkyl compound. The aluminium alkyl compound is preferably trialkyl aluminium such as trimethylaluminium, triethylaluminium, tri-isobutylaluminium or tri-n-octylaluminium. However, it may also be an alkylaluminium halide, such as diethylaluminium chloride, dimethylaluminium chloride and ethylaluminium sesquichloride.

Suitable external electron donors used in polymerisation are well known in the art and include ethers, ketones, amines, alcohols, phenols, phosphines and silanes. Silane type external donors are typically organosilane compounds containing Si-OCOR, Si-OR, or Si-NR$_2$ bonds, having silicon as the central atom, and R is an alkyl, alkenyl, aryl, arylalkyl or cycloalkyl with 1-20 carbon atoms are known in the art.

Examples of suitable catalysts and compounds in catalysts are shown in among others, in WO 87/07620, WO 92/21705, WO 93/11165, WO 93/11166, WO 93/19100, WO 97/36939, WO 98/12234, WO 99/33842, WO 03/000756, WO 03/000757, WO 03/000754, WO 03/000755, WO 2004/029112, EP 2610271, WO 2012/007430. WO 92/19659, WO 92/19653, WO 92/19658, US 4382019, US 4435550, US 4465782, US 4473660, US 4560671, US 5539067, US5618771, EP45975, EP45976, EP45977, WO 95/32994, US 4107414, US 4186107, US 4226963, US 4347160, US 4472524, US 4522930, US 4530912, US 4532313, US 4657882, US 4581342, US 4657882.

The obtained PP copolymer is then compounded together with the additives (ii) and one or more of optional components (iii) and (iv) in a known manner. The compounding can be effected in a conventional extruder e.g. as described above and the obtained melt mix is produced to an article or, preferably, pelletised before used for the end application. Part or all of the additives or optional components may be added during the compounding step.

**Layer element (LE) of the invention**

Accordingly, at least one layer of the layer element (LE) may comprise one or more of a filler, pigment, carbon black or flame retardant, as defined above or in claims, preferably at least one layer of the layer element (LE) comprises one or more of a filler, pigment, carbon black or flame retardant, more preferably at least two layers, preferably at least the second layer, of the layer element (LE) comprises a pigment or filler, preferably pigment, as defined above or in claims.

The first layer and second layer of the layer element (LE) are in adhering contact to each other. I.e. the surface of the first layer and the surface of the second layer which are facing each other are in adhering contact.

The adhering contact is defined herein in that the adhering surfaces of the first layer and the second layer are in direct contact to each other or, alternatively, there is an adhesive layer between the adhering surfaces of the first layer and the second layer. In case of the adhesive layer, said layer may be based on a functionalised polymer having adhesion enhancing effect. Said functionalised polymer is a polymer which is functionalised e.g. by grafting. For instance, polar functional groups, such as maleic anhydride (MAH), can be grafted to a polyolefin to form functional polymers thereof. Functionalised polymers as adhesives are well known in the field of adhesives and can be chosen by a skilled person.

As already mentioned, the layer element (LE) may contain more than the at least first layer and the second layer. The further layer(s) can be either on side opposite of the side (surface) of the first layer adhering to the side (surface) of the second layer or on side opposite of the side (surface) of the second layer adhering to the side (surface) of the first layer opposite, or on both on said opposite sides of the first layer and the second layer.

The invention further provides a process for producing the layer element (LE) wherein the process comprises a step of

- adhering the first and second layer of the layer element (LE) together by extrusion or lamination and
- recovering the formed layer element (LE).

In one embodiment the first layer and the second layer of layer element (LE) are produced by extrusion, preferably by coextrusion.

The term "extrusion" means herein that the at least two layers of the layer element (LE) can be extruded in separate steps or in a same extrusion step, as well known in the art. One and preferable embodiment of the "extrusion" process for producing the at least two layers of the layer element (LE) is a coextrusion process. The term "coextrusion" means herein that the at least two layers of the layer element (LE) can be coextruded in a same extrusion step, as well known in the art. The term "coextrusion" means herein that, in addition to said at least two layers, also all or part of the additonal layers of the layer element (LE), if present, can be formed simultaneously using one or more extrusion heads.

The extrusion and preferable coextrusion step can be carried out for example using a blown film or cast film extrusion process. Both processes have a well-known meaning and are well described in the literature of the field of the art.

Moreover, the extrusion step and the preferable coextrusion step, can be effected in any conventional film extruder, preferably in a conventional cast film extruder, e.g. in a single or twin screw extruder. Extruder equipments, like cast film extruder equipments, are well described in the literature and commercially available.

The extrusion conditions are depend on the chosen layer materials and can be chosen by a skilled person.

Preferably the extrusion, preferably the coextrusion, of the layer element (LE), is carried by cast film extrusion, preferably by cast film coextrusion.

In extrusion embodiment, in case of an adhesive layer between the adhering sides of the first and second layer, the adhesive layer is typically extruded or coextruded during the extrusion step of the first and second layer.

Part or all of said optional additional layer(s) of the layer element (LE) can be extruded, like coextruded, on the side of the first layer or the second layer, or on the side of both the first and second layer, opposite to side which is in adhering contact with the first layer and the second layer. The extrusion of said optional additional layer(s) can be carried out during the extrusion, preferably during the coextrusion, step of the first layer and the second layer. Alternatively or additionally, part or all of said optional additional layer(s) can be laminated to said opposite side of one or both of the first layer and second layer after the extrusion, preferably coextrusion, step of the first layer and second layer.

In an alternative embodiment, the layer element (LE) is produced by laminating at least the first layer and the second layer to an adhering contact. The lamination is carried out in a conventional lamination process using conventional lamination equipment well known in the art. In a typical lamination process, the separately formed first layer and second layer of the layer element (LE) of the invention are arranged to form of the layer element (LE) assembly; then said layer element (LE) assembly is subjected to a heating step typically in a lamination chamber at evacuating conditions; after that said layer element (LE) assembly is subjected to a pressing step to build and keep pressure on the layer element (LE) assembly at the heated conditions for the lamination of the assembly to occur; and subsequently the layer element (LE) is subjected to a recovering step to cool and remove the obtained layer element (LE).

Similarly in the alternative lamination embodiment, in addition to the at least first layer and second layer, the layer element (LE) may comprise further layer(s) on side opposite to adhering side of one or both of the first layer and the second layer. In that case part or all of said optional additional layer(s) of the layer element (LE) can be laminated and/or extruded on the side of first or second layer, or on the side of both the first and second layer, opposite to side which is in adhering contact with the first layer and the second layer. Extrusion of optional additional layer(s) can be done before the lamination step of the first and second layer. The lamination of optional additional layer(s) can be carried, in a step preceding the lamination step of the first and second layer, during the lamination step of the first layer and second layer, or after the lamination step of the first layer and second layer.

In the alternative embodiment, wherein the first and second layers of the layer element (LE) is produced by lamination, then the adhesive layer is applied using known techniques either on the surface of the first layer or on the surface of the second layer, which surface is facing the surface of the other of the first and second layers.

The formed layer element (LE) can be further treated, if desired, for instance to improve the adhesion of the layer element (LE) or to modify the outer surfaces of the layer element (LE). For example, the outer sides (opposite to "adhering" sides) of the first layer and the second layer, or in case of producing the layer element (LE) by lamination, then also the "adhering" sides of the first and second layer, can be surface treated using conventional techniques and equipments which are well-known for a skilled person.

The most preferable process for producing the layer element of the invention is said extrusion process, preferably said coextrusion process. More preferably, the extrusion process for producing the layer element (LE) is a cast film extrusion, more preferably a cast film coextrusion process.

Accordingly, the preferable process for producing the layer element (LE) of the invention is an extrusion process, preferably a coextrusion process, which comprises the steps of:

- mixing in separate mixing devices, preferably meltmixing in separate extruders, the PE composition of the first layer and, respectively, the PP composition of the second layer;
- applying, preferably applying simultaneously, the melt mix of the composition of the first layer and, respectively, the composition of the second layer via a die to form a layer element (LE) of at least the first layer and the second layer, wherein said first and second layers are in adhering contact to each other;
- recovering the obtained layer element (LE).

As well known a meltmix of the polymer composition or component(s) thereof is applied to form a layer. Meltmixing means herein mixing above the melting or softening point of at least the major polymer component(s) of the obtained mixture and is carried out for example, without limiting to, in a temperature of at least 10-15°C above the melting or softening point of polymer component(s). The mixing step can be carried out in an extruder, like film extruder, e.g. in cast film extruder. The meltmixing step may comprise a separate mixing step in a separate mixer, e.g. kneader, arranged in connection and preceding the extruder of the layer element production line. Mixing in the preceding separate mixer can be carried out by mixing with or without external heating (heating with an external source) of the component(s).

In the above preferable process, the extrusion process is preferably a cast film extrusion, preferably a cast film coextrusion process.

In case of an adhesive layer between the first layer and the second layer of the layer element (LE), then the adhesive layer is preferably applied during the extrusion, preferably during the coextrusion, process, as well known and within the skills of a skilled person in the field of extrusion.

Preferably the layer element (LE) is produced in a cast film extrusion process, preferably in a cast film coextrusion process, without any adhesive layer in between the surfaces of the first and second layer facing each other.

As said extrusion process for forming the layer element (LE) of the invention can also comprise a further step subsequent to the extrusion, e.g. a further treatment step or lamination step, preferably subsequent to the extrusion step as described above. Preferably, said first layer of the layer element (LE) of the invention comprises at least 70 wt%, preferably at least 80 wt%, preferably at least 90 wt%, preferably 90 to 100 wt%, preferably consists of, the PE composition of the invention.

Also preferably, the second layer of the layer element comprises at least 35, preferably at least 50 wt%, preferably at least 60 wt%, preferably at least 60 to 100 wt%, preferably at least 70 to 100 wt%, of the PP composition of the invention.

The thickness of the first layer of the layer element (LE), can vary depending on the desired PV module, as evident for a skilled person. As an example only, the thickness of said first layer can typically be up to 2 mm, preferably up to 1 mm, typically 0.3 to 0.6 mm. Naturally, the thickness depends on the desired final end application and can be chosen by a skilled person.

The thickness of the second layer of the layer element (LE), can vary depending on the desired PV module, as evident for a skilled person. As an example only, the thickness of said second layer can typically be up to 700, like 25 to 700, suitably 50 to 700, suitably 90 to 700, suitably 100 to 500, such as 100 to 400, $\mu$m. Naturally, the thickness depends on the desired final end application and can be chosen by a skilled person.

**Article of the invention**

The article comprising the layer element (LE) can be any article wherein the properties of the present of the first and/or, preferably and, of the second layer are for instance desirable or feasible.

The layer element (LE) can be part of an article or form the article, like film.

As non-limiting examples of such articles, extruded articles or moulded articles or combinations thereof can be mentioned. For instance the molded articles can be for packaging (including boxes, cases, containers, bottles etc), for household applications, for parts of vehicles, for construction and for electronic devices of any type. Extruded articles can be e.g. films of different types for any purposes, like plastic bags or packages, e.g. wrappers, shrink films etc.; electronic devices of any type; pipes etc., which comprise the layer element (LE). The combinations of molded and extruded article are e.g. molded containers or bottles comprising an extruded label which comprises the layer element (LE).

In one embodiment the article is a multilayer film comprising, preferably consisting of, the layer element (LE) of said at least two layers. In this embodiment the layer element of the article is preferably a film for various end applications e.g. for packaging applications without limiting thereto. In this invention the term "film" covers also thicker sheet structures e.g. for thermoforming.

In a second embodiment the article is an assembly comprising two or more layer elements, wherein at least one layer element is the layer element (LE) of said at least two layers. The further layer element(s) of the assembly can be different or same as layer element (LE).

The second embodiment is the preferable embodiment of the invention.

The assembly of the preferable second embodiment is preferably a photovoltaic (PV) module comprising a photovoltaic element and one or more further layer elements, wherein at least one layer element is the layer element (LE) of said at least two layers of the invention.

The preferred photovoltaic (PV) module of the invention comprises, in the given order, a protective front layer element, preferably a glass layer element, a front encapsulation layer element, a photovoltaic element, and the layer element (LE) of said at least to layers.

In this preferable embodiment the layer element (LE) is multifunctional, i.e. the layer element (LE) of the invention functions both as a rear encapsulation layer element and as the protective back layer element. More preferably, the first layer functions as an encapsulation layer element and the second layer of the layer element (LE) functions as the protective back layer element which is also called herein as backsheet layer element. Naturally, as said above under "Layer element (LE) of the invention", there may be additional layers attached to the outer surface of the first layer to enhance the "encapsulation layer element" functionality. Further naturally, there may be additional layers attached to the outer surface of the second layer to enhance the "protective back layer element" functionality. Such additional layers can be introduced to the first layer and, respectively, to the second layer by extrusion, like coextrusion, or by lamination, or by combination thereof, in any order.

In the preferred photovoltaic (PV) module of the invention, the side of the first layer opposite to side adhering to the second layer of the layer element (LE) is preferably in adhering contact with a photovoltaic element of the PV module.

Moreover, the side of the second layer opposite to side adhering to the first layer of the layer element (LE) can be in adhering contact with further layers or layer elements, as known in the art of backsheet layer elements of PV module.

The final photovoltaic module can be rigid or flexible.

Moreover, the final PV module of the invention can for instance be arranged to a metal, such as aluminum, frame.

All said terms have a well-known meaning in the art.

The materials of the above elements of the above elements other than the layer element (LE) of the invention are well known in the prior art and can be chosen by a skilled person depending on the desired PV module.

The above exemplified layer elements other than the layer element (LE) can be monolayer or multilayer elements. Moreover, said other layer elements or part of the layers thereof can be produced by extrusion, e.g. coextrusion, by lamination, or by a combination of extrusion and lamination, in any order, depending on the desired end application, as well known in the art.

The "photovoltaic element" means that the element has photovoltaic activity. The photovoltaic element can be e.g. an element of photovoltaic cell(s), which has a well-known meaning in the art. Silicon based material, e.g. crystalline silicon, is a non-limiting example of materials used in photovoltaic cell(s). Crystalline silicon material can vary with respect to crystallinity and crystal size, as well known to a skilled person. Alternatively, the photovoltaic element can be a substrate layer on one surface of which a further layer or deposit with photovoltaic activity is subjected, for example a glass layer, wherein on one side thereof an ink material with photovoltaic activity is printed, or a substrate layer on one side thereof a material with photovoltaic activity is deposited. For instance, in well-known thin film solutions of photovoltaic elements e.g. an ink with photovoltaic activity is printed on one side of a substrate, which is typically a glass substrate.

The photovoltaic element is most preferably an element of photovoltaic cell(s).

"Photovoltaic cell(s)" means herein a layer element(s) of photovoltaic cells, as explained above, together with connectors.

The detailed description given above for "Layer element (LE) of the invention" applies to layer element (LE) present in an article, preferable in a photovoltaic module.

Accordingly, there can be an adhesive layer between the side (surface) of the first layer the side (surface) of the second layer of the layer element (LE) which are in adhering contact to each other as described above under "Layer element (LE) of the invention".

In some embodiments of the PV module there can also be an adhesive layer between the different layer elements and/or between the layers of a multilayer element, as well known in the art. Such adhesive layers have the function to improve the adhesion between the two elements and have a well-known meaning in the lamination field. The adhesive layers are differentiated from the other functional layer elements of the PV module, e.g. those as specified above, below or in claims, as evident for a skilled person in the art.

Preferably, there is no adhesive layer between the photovoltaic element and the front encapsulation layer element. Alternatively, preferably there is no adhesive layer between the photovoltaic layer element and the layer element (LE). More preferably, there is no adhesive layer between the photovoltaic element and the front encapsulation layer element and there is no adhesive layer between the photovoltaic layer element and the layer element (LE).

As well-known in the PV field, the thickness of the above mentioned elements, as well as any additional elements, of an article, preferably of a laminated photovoltaic module, of the invention can vary depending on the desired end use application, like the desired photovoltaic module embodiment, and can be chosen accordingly by a person skilled in the PV field.

As a non-limiting example only, the thickness of a photovoltaic element, e.g. an element of monocrystalline photovoltaic cell(s), is typically between 100 to 500 microns.

The thickness of the first layer of the layer element (LE) of the photovoltaic (PV) module of the invention, which preferably functions as a rear encapsulation layer element, can naturally vary depending on the desired PV module, as evident for a skilled person. As an example only, the thickness of said first layer can typically be up to 2 mm, preferably up to 1 mm, typically 0.3 to 0.6 mm. As said, naturally, the thickness depends on the desired final end application and can be chosen by a skilled person.

Similarly, the thickness of the second layer of the layer element (LE) together with optional further layer(s), which second layer preferably functions as a protective back layer element (backsheet element) or part of such protective back layer element of the photovoltaic (PV) module of the invention, can naturally vary depending on the desired PV module application, as evident for a skilled person. As an example only, the thickness of said second layer of the layer element (LE) of the preferable PV module can typically be up to 700, like 25 to 700, suitably 50 to 700, suitably 90 to 700, suitably 100 to 500, such as 100 to 400, $\mu$m. Naturally, as said, the thickness depends on the desired final end application and can be chosen by a skilled person.

The layer element (LE) of the article, preferably of the photovoltaic module, can be produced as described above under "Layer element (LE) of the invention".

The separate further elements of PV module other than the layer element (LE) can be produced in a manner well known in the photovoltaic field or are commercially available. The production of the layer element (LE) is disclosed above under the description of layer element (LE).

Figure 1 is a schematic picture of a typical PV module of the invention comprising a protective front layer element (1), a front encapsulation layer element (2), a photovoltaic element (3) and a layer element (LE) of the invention (combination of (4)+(5)), which functions as a rear encapsulation layer element (4) and as a protective back layer element (5).

The invention further provides a process for producing an assembly of the invention wherein the process comprises the steps of:

- assembling the layer element (LE) and further layer element(s) to an assembly;
- laminating the elements of the assembly in elevated temperature to adhere the elements together; and
- recovering the obtained assembly.

The layer elements can be provided separately to the assembling step. Or, alternatively, part of the layer elements or part of the layers of two layer elements can be adhered together, i.e. integrated, already before providing to the assembling step.

The preferred process for producing the assembly is a process for producing a photovoltaic (PV) module by

- assembling the photovoltaic element, the layer element (LE) and optional further layer elements to a photovoltaic (PV) module assembly;
- laminating the layer elements of the photovoltaic (PV) module assembly in elevated temperature to adhere the elements together; and
- recovering the obtained photovoltaic (PV) module.

The conventional conditions and conventional equipment are well known and described in the art of the photovoltaic module and can be chosen by a skilled person.

As said part of the layer elements can be in integrated form, i.e. two or more of said PV elements can be integrated together, e.g. by lamination, before subjecting to the lamination process of the invention.

Preferable embodiment of the process for forming the preferable photovoltaic (PV) module of the invention, is a lamination process comprising,

- an assembling step to arrange a photovoltaic element and the layer element (LE) of the invention to form of a multilayer assembly, wherein the first layer of the layer element (LE) is arranged in contact with the photovoltaic element, preferably an assembling step to arrange, in a given order, a front protective layer element, a front encapsulating layer element, a photovoltaic element and a layer element (LE) of the invention to form of a multilayer assembly, wherein the first layer of the layer element (LE) is arranged in contact with a photovoltaic element;
- a heating step to heat up the formed PV module assembly optionally, and preferably, in a chamber at evacuating conditions;
- a pressing step to build and keep pressure on the PV module assembly at the heated conditions for the lamination of the assembly to occur; and
- a recovering step to cool and remove the obtained PV module comprising the layer element (LE).

The lamination process is carried out in laminator equipment which can be e.g. any conventional laminator which is suitable for the multilaminate to be laminated, e.g. laminators conventionally used in the PV module production. The choice of the laminator is within the skills of a skilled person. Typically, the laminator comprises a chamber wherein the heating, optional, and preferable, evacuation, pressing and recovering (including cooling) steps take place.

**Determination Methods**

Melt Flow Rate: The melt flow rate (MFR) is determined according to ISO 1133 and is indicated in g/10 min. The MFR is an indication of the flowability, and hence the processability, of the polymer. The higher the melt flow rate, the lower the viscosity of the polymer. The $MFR_2$ of polypropylene is measured at a temperature 230 °C and a load of 2.16 kg. The $MFR_2$ of polyethylene is measured at a temperature 190 °C and a load of 2.16 kg.

Density: ISO 1183, measured on compression moulded plaques.

Comonomer contents:

The content (wt% and mol%) of polar comonomer present in the polymer (a) and the content (wt% and mol%) of silane group(s) containing units (preferably comonomer) present in the polymer (a):

Quantitative nuclear-magnetic resonance (NMR) spectroscopy was used to quantify the comonomer content of the polymer composition or polymer as given above or below in the context.

Quantitative $^1$H NMR spectra recorded in the solution-state using a Bruker Advance III 400 NMR spectrometer operating at 400.15 MHz. All spectra were recorded using a standard broad-band inverse 5 mm probehead at 100°C using nitrogen gas for all pneumatics. Approximately 200 mg of material was dissolved in 1,2-tetrachloroethane-$d_2$ (TCE-$d_2$) using ditertiarybutylhydroxytoluen (BHT) (CAS 128-37-0) as stabiliser. Standard single-pulse excitation was employed utilising a 30 degree pulse, a relaxation delay of 3 s and no sample rotation. A total of 16 transients were acquired per spectra using 2 dummy scans. A total of 32k data points were collected per FID with a dwell time of 60 $\mu$s, which corresponded to to a spectral window of approx. 20 ppm. The FID was then zero filled to 64k data points and an exponential window function applied with 0.3 Hz line-broadening. This setup was chosen primarily for the ability to resolve the quantitative signals resulting from methylacrylate and vinyltrimethylsiloxane copolymerisation when present in the same polymer.

Quantitative $^1$H NMR spectra were processed, integrated and quantitative properties determined using custom spectral analysis automation programs. All chemical shifts were internally referenced to the residual protonated solvent signal at 5.95 ppm. When present characteristic signals resulting from the incorporation of vinylacytate (VA), methyl acrylate (MA), butyl acrylate (BA) and vinyltrimethylsiloxane (VTMS), in various comonomer sequences, were observed (Randell89). All comonomer contents calculated with respect to all other monomers present in the polymer.

The vinylacytate (VA) incorporation was quantified using the integral of the signal at 4.84 ppm assigned to the *VA sites, accounting for the number of reporting nuclie per comonomer and correcting for the overlap of the OH protons from BHT when present:

$$VA = (\ I_{*VA} - (I_{ArBHT})/2)\ /\ 1$$

The methylacrylate (MA) incorporation was quantified using the integral of the signal at 3.65 ppm assigned to the 1MA sites, accounting for the number of reporting nuclie per comonomer:

$$MA = I_{1MA} / 3$$

The butylacrylate (BA) incorporation was quantified using the integral of the signal at 4.08 ppm assigned to the 4BA sites, accounting for the number of reporting nuclie per comonomer:

$$BA = I_{4BA} / 2$$

The vinyltrimethylsiloxane incorporation was quantified using the integral of the signal at 3.56 ppm assigned to the 1VTMS sites, accounting for the number of reporting nuclei per comonomer:

$$VTMS = I_{1VTMS} / 9$$

Characteristic signals resulting from the additional use of BHT as stabiliser, were observed. The BHT content was quantified using the integral of the signal at 6.93 ppm assigned to the ArBHT sites, accounting for the number of reporting nuclei per molecule:

$$BHT = I_{ArBHT} / 2$$

The ethylene comonomer content was quantified using the integral of the bulk aliphatic (bulk) signal between 0.00 - 3.00 ppm. This integral may include the 1VA (3) and $\alpha$VA (2) sites from isolated vinylacetate incorporation, □MA and $\alpha$MA sites from isolated methylacrylate incorporation, 1BA (3), 2BA (2), 3BA (2), □BA (1) and $\alpha$BA (2) sites from isolated butylacrylate incorporation, the □VTMS and $\alpha$VTMS sites from isolated vinylsilane incorporation and the aliphatic sites from BHT as well as the sites from polyethylene sequences. The total ethylene comonomer content was calculated based on the bulk integral and compensating for the observed comonomer sequences and BHT:

$$E = (1/4)*[ I_{bulk} - 5*VA - 3*MA - 10*BA - 3*VTMS - 21*BHT ]$$

It should be noted that half of the $\alpha$ signals in the bulk signal represent ethylene and not comonomer and that an insignificant error is introduced due to the inability to compensate for the two saturated chain ends (S) without associated branch sites. The total mole fractions of a given monomer (M) in the polymer was calculated as:

$$fM = M / ( E + VA + MA + BA + VTMS )$$

The total comonomer incorporation of a given monomer (M) in mole percent was calculated from the mole fractions in the standard manner:

$$M [mol\%] = 100 * fM$$

The total comonomer incorporation of a given monomer (M) in weight percent was calculated from the mole fractions and molecular weight of the monomer (MW) in the standard manner:

$$M [wt\%] = 100 * ( fM * MW) / ( ( fVA * 86.09) + (fMA * 86.09) + (fBA * 128.17) +$$
$$(fVTMS * 148.23) + ((1-fVA-fMA-fBA-fVTMS) * 28.05) )$$

randall89: J. Randall, Macromol. Sci., Rev. Macromol. Chem. Phys. 1989, C29, 201.

If characteristic signals from other specific chemical species are observed the logic of quantification and/or compensation can be extended in a similar manor to that used for the specifically described chemical species. That is, identification of characteristic signals, quantification by integration of a specific signal or signals, scaling for the number of reported nuclei and compensation in the bulk integral and related calculations. Although this process is specific to the specific chemical species in question the approach is based on the basic principles of quantitative NMR spectroscopy of polymers and thus can be implemented by a person skilled in the art as needed.

Rheological properties:

Dynamic Shear Measurements (frequency sweep measurements)

The characterisation of melt of polymer composition or polymer as given above or below in the context by dynamic shear measurements complies with ISO standards 6721-1 and 6721-10. The measurements were performed on an Anton Paar MCR501 stress controlled rotational rheometer, equipped with a 25 mm parallel plate geometry. Measurements were undertaken on compression moulded plates, using nitrogen atmosphere and setting a strain within the linear viscoelastic regime. The oscillatory shear tests were done at 190 °C applying a frequency range between 0.01 and 600 rad/s and setting a gap of 1.3 mm.

In a dynamic shear experiment the probe is subjected to a homogeneous deformation at a sinusoidal varying shear strain or shear stress (strain and stress controlled mode, respectively). On a controlled strain experiment, the probe is subjected to a sinusoidal strain that can be expressed by

$$\gamma(t) = \gamma_0 \sin(\omega t) \qquad (1)$$

If the applied strain is within the linear viscoelastic regime, the resulting sinusoidal stress response can be given by

$$\sigma(t) = \sigma_0 \sin(\omega t + \delta) \qquad (2)$$

where

$\sigma_0$ and $\gamma_0$ are the stress and strain amplitudes, respectively
$\omega$ is the angular frequency
$\delta$ is the phase shift (loss angle between applied strain and stress response)
t is the time

Dynamic test results are typically expressed by means of several different rheological functions, namely the shear storage modulus G', the shear loss modulus, G", the complex shear modulus, G*, the complex shear viscosity, $\square$*, the dynamic shear viscosity, $\square$', the out-of-phase component of the complex shear viscosity $\square$'' and the loss tangent, tan $\square$ $\square$ which can be expressed as follows:

$$G' = \frac{\sigma_0}{\gamma_0}\cos\delta \ [\text{Pa}] \qquad (3)$$

$$G'' = \frac{\sigma_0}{\gamma_0}\sin\delta \ [\text{Pa}] \qquad (4)$$

$$G^* = G' + iG'' \ [\text{Pa}] \qquad (5)$$

$$\eta^* = \eta' - i\eta'' \ [\text{Pa.s}] \qquad (6)$$

$$\eta' = \frac{G''}{\omega} \ [\text{Pa.s}] \qquad (7)$$

$$\eta'' = \frac{G'}{\omega} \ [Pa.s] \qquad\qquad (8)$$

Besides the above mentioned rheological functions one can also determine other rheological parameters such as the so-called elasticity index *EI(x)*. The elasticity index *EI(x)* is the value of the storage modulus, G' determined for a value of the loss modulus, G" of x kPa and can be described by equation (9).

$$EI(x) = G' \ for \ (G'' = x\,kPa) \ [Pa] \qquad\qquad (9)$$

For example, the EI(5kPa) is the defined by the value of the storage modulus G', determined for a value of G" equal to 5 kPa.

Shear Thinning Index $(SHI_{0.05/300})$ is defined as a ratio of two viscosities measured at frequencies 0.05 rad/s and 300 rad/s, $\mu_{0.05}/\ \mu_{300}$.

References:

[1] Rheological characterization of polyethylene fractions" Heino, E.L., Lehtinen, A., Tanner J., Seppälä, J., Neste Oy, Porvoo, Finland, Theor. Appl. Rheol., Proc. Int. Congr. Rheol, 11th (1992), 1, 360-362

[2] The influence of molecular structure on some rheological properties of polyethylene", Heino, E.L., Borealis Polymers Oy, Porvoo, Finland, Annual Transactions of the Nordic Rheology Society, 1995.).

[3] Definition of terms relating to the non-ultimate mechanical properties of polymers, Pure & Appl. Chem., Vol. 70, No. 3, pp. 701-754, 1998.

Comonomer content measurement present in PP polymer (b):

The comonomer content was determined by quantitative Fourier transform infrared spectroscopy (FTIR) after basic assignment calibrated via quantitative $^{13}C$ nuclear magnetic resonance (NMR) spectroscopy in a manner well known in the art. Thin films are pressed to a thickness of between 100-500 micrometer and spectra recorded in transmission mode.

Specifically, the ethylene content of a polypropylene-co-ethylene copolymer is determined using the baseline corrected peak area of the quantitative bands found at 720-722 and 730-733 $cm^{-1}$. Specifically, the butene or hexene content of a polypropylene copolymer is determined using the baseline corrected peak area of the quantitative bands found at 1377-1379 $cm^{-1}$. Quantitative results are obtained based upon reference to the film thickness.

The comonomer content is herein assumed to follow the mixing rule (equation 2):

$$C_b = w_1 \cdot C_1 + w_2 \cdot C_2 \quad (eq.\,2)$$

Where C is the content of comonomer in weight-%, w is the weight fraction of the component in the mixture and subscripts b, 1 and 2 refer to the overall mixture, component 1 and component 2, respectively.

As it is well known to the person skilled in the art the comonomer content in weight basis in a binary copolymer can be converted to the comonomer content in mole basis by using the following equation

$$c_m = \cfrac{1}{1 + \left(\cfrac{1}{c_w} - 1\right) \cdot \cfrac{MW_c}{MW_m}} \quad (eq.\,3)$$

where $c_m$ is the mole fraction of comonomer units in the copolymer, $c_w$ is the weight fraction of comonomer units in the copolymer, $MW_c$ is the molecular weight of the comonomer (such as ethylene) and $MW_m$ is the molecular weight of the main monomer (i.e., propylene).

Melting temperature ($T_m$) and heat of fusion ($H_f$): measured with Mettler TA820 differential scanning calorimetry (DSC) on 5 to 10 mg samples. DSC is run according to ISO 3146 / part 3 /method C2 in a heat / cool / heat cycle with a scan rate of 10 °C/min (heating and cooling) in the temperature range of +23 to +210°C. The melting temperature and heat of fusion ($H_f$) are determined from the second heating step. The melting temperatures were taken as the peaks of endotherms.

Xylene cold soluble (XCS): The amount of xylene cold soluble fraction was determined according to ISO 16152. The amount of polymer which remains dissolved at 25 °C after cooling is given as the amount of xylene soluble polymer.

The content of xylene soluble polymer is herein assumed to follow the mixing rule (equation 4):

$$XS_b = w_1 \cdot XS_1 + w_2 \cdot XS_2 \quad (eq.4)$$

Where XCS is the content of xylene soluble polymer in weight-%, w is the weight fraction of the component in the mixture and subscripts b, 1 and 2 refer to the overall mixture, component 1 and component 2, respectively.

Vicat softening temperature:

measured according to ASTM D 1525 method A (50°C/h, 10N).

Tensile Modulus, Tensile stress at yield and Tensile strain at break:

**Injection moulded specimens:** are prepared as described in EN ISO 1873-2 (dog bone shape, 4 mm thickness) and measured according to ISO 527-2 (cross head speed = 1 mm/min; 23 °C) for injection molded sample specimen

**Monolayer film samples:** are prepared as prepared below under "Film preparation" specified below and measured according to ISO 527-3 using the below given conditions.

**Monolayer Film preparation:** 200 $\mu$m cast films were prepared on a Plastic Maschinenbau extruder with 3 heating zones equipped with a PP screw with a diameter of 30 mm, a 200 mm die with a die gap of 0.5 mm. The melt temperature of 250°C and a chill roll temperature of 60°C were used

**Film samples (200 $\mu$m monolayer):** Before the first test, the film sample must be stored at 23°C /50% RH over a period of 96 hours. The test specimen shall be cut with a film cutter so that the edges are smooth, free from notches and have an exact width. The form of test specimen is a strip 15 mm wide and not less than 150 mm long. The specimens were cut in machine direction.

**Test conditions film tensile test:** The test is performed according to ISO 527-3 using the following test condition set:

Test conditions: 23°C / 50% RH
Preload: app. 0,2N
Speed of preload: 2mm/min
Speed of E-Modulus: 1mm/min
Speed of testing: 200mm/min
Clamping distance: 100mm
Start of E-Modulus testing: 0,05%
End of E-Modulus testing: 0,25%

Interlayer adhesion of co-extruded films and laminates:

The adhesive bond forces of co-extruded films and laminates were tested on a universal testing machine (Zwick Z1.0) based on modified methods of DIN 55329 and ISO 6133. 10 specimens (length: approx. 300 mm / width: 15 mm) were prepared (cut) from each sample in machine direction. The layers were separated manually at the interface using a scalpel. The separated layers were mounted between two pneumatic clamps and the force required to pull the layers apart was measured. The first measurement obtained on each specimen was discarded to eliminate a potential effect of the manual separation procedure.

**Test parameters:**

Clamping distance: 100 mm
Pre-load: 0.2 N
Speed pre-load: 2 mm/min

Pre-measurement travel: 50 mm
Measurement travel: 100 mm
Test speed: 100 mm/min

As a test result the average force (10 measurements, unit: N) needed for separation of the co-extruded layers and, respectively, laminated layers is given. Each specimen was inspected visually and the failure type was determined after testing.

**Experimental Part**

**Polymerisation example for producing copolymer (a) of the PE composition of the first layer of the layer element (LE): Copolymer of ethylene (a2) (herein referred also as polymer (a)) with methyl acrylate comonomer and with vinyl trimethoxysilane comonomer**

Polymer (a) was produced in a commercial high pressure tubular reactor at a pressure 2500-3000 bar and max temperature 250-300 °C using conventional peroxide initiatior. Ethylene monomer, methyl acrylate (MA) polar comonomer and vinyl trimethoxy silane (VTMS) comonomer (silane group(s) containing comonomer) were added to the reactor system in a conventional manner. CTA was used to regulate MFR as well known for a skilled person. After having the information of the property balance desired for the inventive final polymer (a), the skilled person can control the process to obtain the polymer (a).

The amount of the vinyl trimethoxy silane units, VTMS, (=silane group(s) containing units), the amount of MA and $MFR_2$ are given in the table 1.

The properties in below tables were measured from the polymer (a) as obtained from the reactor or from a layer sample as indicated below.

Table 1: Product properties of Inventive Polymer (a) example

| Test polymer | Polymer (a) |
|---|---|
| Properties of the polymer obtained from the reactor | |
| $MFR_{2,16}$, g/10 min | 2.0 |
| Methyl acrylate (MA) content, mol% (wt%) | 8.1 (21) |
| Melt Temperature, °C | 92 |
| VTMS content, mol% (wt%) | 0.41 (1.8) |
| Density, kg/m³ | 948 |
| SHI (0.05/300), 150°C | 70 |

In above table 1 MA denotes the content of Methyl Acrylate comonomer present in the polymer and, respectively, VTMS content denotes the content of vinyl trimethoxy silane comonomer present in the polymer.

The polymer (a) was compounded in conventional amounts with conventional antioxidant (CAS number 32687-78-8) and UV-stabilising hindered amine compound (CAS number 71878-19-8, 70624-18-9 (in US)) to produce the PE composition of the first layer of the layer element (LE).

**Polymerisation Example for producing polymer (b) (HECO A) of the PP composition of the second layer of the layer element (LE):**

**Catalyst preparation:**

Catalyst preparation for HECO A:

First, 0.1 mol of $MgCl_2 \times 3$ EtOH was suspended under inert conditions in 250 ml of decane in a reactor at atmospheric pressure. The solution was cooled to the temperature of -15°C and 300 ml of cold $TiCl_4$ was added while maintaining the temperature at said level. Then, the temperature of the slurry was increased slowly to 20 °C. At this temperature, 0.02 mol of diethylhexylphthalate (DOP) was added to the slurry. After the addition of the phthalate, the temperature was raised to 135 °C during 90 minutes and the slurry was allowed to stand for 60 minutes. Then, another 300 ml of $TiCl_4$ was added and the temperature was kept at 135 °C for 120 minutes. After this, the catalyst was filtered from the liquid and washed six times with 300 ml heptane at 80 °C. Then, the solid catalyst component was filtered and dried. Catalyst and its preparation concept is described in general e.g. in patent publications EP 491 566, EP 591 224 and EP 586 390.

Then triethylaluminium (TEAL), dicyclopentyldimethoxysilane (DCPDMS) as donor (Do), catalyst as produced above and vinylcyclohexane (VCH) were added into oil, like mineral oil, e.g. Technol 68 (kinematic viscosity at 40 °C 62-74 cSt), in amounts so that Al/Ti was 3-4 mol/mol, Al/Do was as well 3-4 mol/mol, and weight ratio of VCH/solid catalyst was 1: 1. The mixture was heated to 60 - 65 °C and allowed to react until the content of the unreacted vinylcyclohexane in the reaction mixture was less than 1000 ppm. Catalyst concentration in the final oil-catalyst slurry was 10 - 20 wt%.

**Polymerisation of HECO A (polymer (b))**

All Pilot scale polymers were produced with a prepolymerisation reactor, one slurry loop reactor and two gas phase reactors.

All Pilot scale polymers were produced with a prepolymerisation reactor, one slurry loop reactor and two gas phase reactors.

Catalyst Feeding

Catalyst was fed continuously to the polymerisation in oil slurry by the piston pump.

*Co-catalyst and Donor*

Triethylaluminium (TEAL) was used as a co-catalyst and dicyclopentyldimethoxysilane (Donor D) was used as an external donor. Actual TEAL and donor feeds are given in table 1.

Prepolymerisation Reactor

The catalyst was flushed with propylene to the prepolymerisation reactor in which also TEAL and D-donor were fed. Prepolymerisation reactor, CSTR, was operated at 30°C and 55 barg pressure. The residence time of the particles in propylene slurry was about 0,38 h.

Loop Reactor

The prepolymerised catalyst component was used in loop reactor and gas phase reactors (GPR) connected in series. The process conditions for the loop reactor are given in table 1.

Gas Phase Reactor 1

Polymer slurry was fed from loop to the gas phase reactor (GPR1) as a direct feed without flash. GPR operating temperatures and pressures are given in table 1.

Gas Phase Reactor 2

The product was transferred from GPR1 to GPR2 as an indirect feed via a flash tank. GPR operating temperatures and pressures are given in table 1.

Product Control

The production split between loop and GPR was controlled to be close to 50/50%. The MFR (2.16 kg / 230°C) was controlled by hydrogen feed.

The PP composition of HECO A (polymer composition of polymer (b))

The polymer powder obtained from GPR2 was further melt homogenised and pelletized using a Coperion ZSK57 co-rotating twin screw extruder with screw diameter 57 mm and LID 22. Screw speed was 200 rpm and barrel temperature 200-220°C.

For HECO A, the following additives were added during the melt homogenisation step:

1000 ppm ADK 25 STAB AO-60 (supplied by Adeka Corporation), 1000 ppm ADK-STAB 2112 RG (supplied by Adeka Corporation) and calcium stearate 500 ppm (CEASIT-AV/T, supplied by Baerlocher). The resulting product is referred herein as polymer composition of polymer (b) which comprised further components for further experiments.

Table 2: Polymerisation conditions

|  | HECO A |
| --- | --- |
| TEAL/Ti [mol/mol] | 390 |
| TEAL/Donor [mol/mol] | 6 |
| TEAL/ C3 [g/t] | 130 |
| Donor/C3 [g/t] | 44 |
| **Prepolymerisation** |  |
| B1 Temperature [°C] | 28 |
| **Loop** |  |
| B2 Temperature [°C] | 61 |
| B2 Pressure (barg) | 44 |
| B2 H2/C3 ratio [mol/kmol] | 8.6 |
| B2 Split [%] | 38.5 |
| **GPR1** |  |
| B3 Temperature [°C] | 79 |
| B3 Pressure (barg) | 15 |
| B3 H2/C3 ratio (mol/kmol) | 124 |
| B3 split [%] | 38.5 |
| **GPR2** |  |
| B4 Temperature (°C) | 60 |
| B4 Pressure (barg) | 15 |
| B4 C2/C3 ratio [mol/kmol] | 550 |
| B4 H2/C2 ratio [mol/kmol] | 500 |
| B4 split [%] | 23 |
| **Final product** |  |
| $MFR_2$ [g/10 min] | 15 |
| Ethene comonomer content [wt.%] | 16 |
| XCS [wt.%] | 34 |
| Melting temp., Tm [°C] | 164 |
| Vicat A [°C] | 125 |
| Density [kg/m$^3$] | 905 |
| Flexural modulus | 800 |

**Further components of the PP composition of the second layer of the layer element (LE)**

Plastomer 1: Engage 8150, supplier ExxonMobil, is an ethylene based octene plastomer, produced in a solution polymerisation process using a metallocene catalyst, $MFR_2$ (190°C) of 0.5 g/10 min and density of 868 kg/m$^3$.
Adhesive: Maleic anhydride (MA) modified polypropylene of ExxonMobil, $MFR_2$ (230°C) of 430 g/10 min, density of 900 kg/m$^3$, MA content of 0.5 to 1.0 wt%, supplier ExxonMobil.

TiO2 are conventional commercial products.

**Preparation of the PP composition of the second layer of the samples.**

The composition was prepared by compounding the polymers with the other components on a co-rotating twin-screw extruder (ZSK32, Coperion) using a screw speed of 400 rpm and a throughput of 90-100 kg/h. The melt temperature ranged from 190-220°C. The components and the amounts thereof are given below under table 3.

Table 3: PP Composition of the second layer of the layer element (LE)

| Components | | | |
|---|---|---|---|
| HECO A | | wt% | 36.1 |
| Plastomer 1 | Engage 8150 | wt% | 18 |
| TiO2 | | wt% | 35 |
| Adhesive | MAH-PP | wt% | 10 |
| Additives as given above | | wt% | 0.85 |

Table 4: Properties of the composition for the second layer of the layer element (LE)

| | MFR | g/10min | 8.3 |
|---|---|---|---|
| | XCS | wt% | 25 |
| 200 $\mu$m monolayer cast film, MD ex Borealis | TENSILE MODULUS, MD | MPa | 896 |
| | TENSILE STRENGTH | MPa | 27 |
| | TENSILE STRAIN AT BREAK | % | 841 |

**Preparation of the layer element (LE) samples of LE1-LE4:**

Polymer composition of polymer (a) was used to produce the first layer of the layer element (LE) and the polymer composition of the polymer (b) was used to produce the second layer of the layer element (LE)

LE1 and LE2 were coextruded as follows:
In case of LE2 the polymer composition of polymer (a) of the first layer was blended with a plastomer 2 (15 wt% based on the combined amount of polymer composition (a) and plastomer 2).

Plastomer 2: Queo 8230, supplier Borealis, is an ethylene based octene plastomer, produced in a solution polymerisation process using a metallocene catalyst, $MFR_2$ (190°C) of 30 g/10 min and density of 882 kg/m$^3$.

**Preparation of the coextruded layer element samples LE1 and LE2:**

2-layer cast films were prepared on a Reifenhäuser multilayer cast film line with a die width of 800 mm. The extruders were equipped with a 60 mm screw with a LID of 30. The thickness of each layer was 200 $\mu$m resulting in a film thickness of 400 $\mu$m. PE composition of the first layer was extruded on the air side and PP composition of the second layer was extruded on the chill roll side of the machine (i.e. the surface of the film of the composition (b) facing the chill roll side). The melt temperature was 210°C in case of polymer (a) and 230°C in case of polymer (b). Each extruder was run at a throughput of 40 kg/h.

**Preparation of the laminated layer element samples LE3 and LE4:**

LE3 and LE4 were prepared using a PEnergy L036LAB vacuum laminator. Sample structure from bottom to top was 20*30 cm a glass element (structured solar glass, 3.2 mm thickness, Teflon release film covering the front glass, the first layer of the polymer composition of polymer (a) was cut in the same dimensions as the glass element, the polymer composition of polymer (b) of the second layer was cut in the same dimensions as the front protective glass element. Samples were further vacuum laminated at 145°C using a lamination cycle program of 4 minutes evacuation time, followed by 2 or 10 minutes pressing time with an upper chamber pressure of 800 mbar. The first and second layer were premade using the same equipment and layer thickness in a manner known to a skilled person.

In all LE1-LE4 samples the layer thickness of the first layer was 200 μm and the layer thickness of the second layer was 200 μm.

Table 5: Adhesion (peeling) results of samples of LE1-LE4 as measured according "Interlayer adhesion of co-extruded films and laminates of the layer element (LE)" as described under Determination methods.

|  | LE1 | LE2 | LE3 | LE4 |
|---|---|---|---|---|
| Sample description | Coex film | Coex film | Laminate, 145°C, 4+2 min | Laminate, 145°C, 4+10 min |
| Average adhesion (peel) force (N) | 12.9 ± 0.13 | 15.5 ± 0.13 | 5.7 ± 0.22 | 8.4 ± 0.4 |
| Adhesion (peeling) results: | elongation (first layer) + peeling | peeling | peeling | peeling |

**Preparation of 1-cell modules for investigation of potential Induced degradation (PID) resistance of different laminates:**

30x30 cm Laminates consisting of Glass/Encapsulant/Cell with connectors/Encapsulant/Polymeric Backsheet were prepared using a PEnergy L036LAB vacuum laminator.
For laminates with polymer (a) based encapsulants with glass and polymeric Backsheet, wherein the polymer of Backsheet was as indicated below, the vacuum lamination occurred at 145°C using a lamination program of 4 minutes evacuation time, followed by 6 minutes pressing time with an upper chamber pressure of 800 mbar.
For laminates containing EVA based encapsulants with glass and polymeric Backsheet, wherein the polymer of Backsheet was as indicated below, the vacuum lamination occurred at 150°C using a lamination program of 5 minutes evacuation time, followed by 10 minutes pressing time with an upper chamber pressure of 800 mbar.
The same type of structured solar glass having a thickness of 3.2 mm (Ducat) was used for all cells. The cell used was a P-type mono crystalline silica cell with three buss-bars and having a dimension of 156×156×0.2 mm and with a cell efficiency of 17.80%. The cell was supplied by ITS with a part number of ITS2-02-60MS3B200C-1780B. The composition of the soldering wire was Sn:Pb:Ag (62:36:2).

**Measurement of resistance to potential induced degradation (PID):**

The measurement was following the principles described of stress method (b) described in IEC TS 62804-1:2015 "Photovoltaic (PV) modules - Test methods for the detection of potential induced degradation - Part 1: Crystalline silicon". The complete glass surface of the module was covered with an aluminium foil and during the testing the cell experienced a 1000V negative potential in relation to the Al-foil, see Figure 3.
Figure 3 shows a schematic description of the PID test set-up.
The PID was performed in environmental chamber at 85°C and a relative humidity of 85% for 96 hours. The impact of the PID were investigated by performing External Quantum Efficiency (EQE) prior and post PID.

**External Quantum Efficiency (EQE) measurement:**

Spectral response was measured with monochromatic light from 300 nm to 1100 nm, with a 5 nm interval, using a Bentham PVE300 PV characterisation system. The illuminated area was 1.5*3 mm. The 1-cell module was placed in such way the illuminated area was in between the Si-cell fingers during measurements, preventing reflection from fingers to influence the results. A total of three measurements of spectral response were done in the middle of each module. The Bentham software automatically converted the spectral response to external quantum efficiency and reported values on EQE are average values between 600-800 nm where the EQE reaches a maximum.

**Polymeric samples used for the PID evaluation**

**Inv LE5:**

The polymer (a) was compounded in conventional amounts with conventional antioxidant (CAS number 32687-78-8) and UV-stabilising hindered amine compound (CAS number 71878-19-8, 70624-18-9 (in US)) to produce the Inventive PE composition (as described above for the first layer) used in the following cast film extrusion step.

The cast film were prepared on a Reifenhäuser cast film line with a die width of 800 mm. The extruder was equipped with a 60 mm screw with a LID ratio of 30. The extruder was run at a throughput of 40 kg/h and the melt temperature was 210°C. The thickness of the film was 500 $\mu$m.

In the PID test the produced layer was used as front and rear encapsulant as given in the table 5.

**Inv BS:**

The Inventive PP composition (as described above for the second layer) having a thickness of 300$\mu$m was produced as above.

In the PID test the produced layer was used as Backsheet as given in the table 5.

**CompEVA 1:**

A commercial "Anti PID" EVA based encapsulant, HangZhou First F406P (supplied by Hangzhou First Applied Material Co.Ltd.), with a thickness of 550$\mu$m.

In the PID test the produced layer was used as front and rear encapsulant as given in the table 5.

**CompEVA 2:**

A commercial EVA based encapsulant, SOLAR EVA RC02B (supplied by Mitsui Chemicals Tocello, Inc.) with a thickness of 550$\mu$m.

In the PID test the produced layer was used as front and rear encapsulant as given in the table 5.

**CompBS1**:

A 325$\mu$m backsheet consisting of three different layers. From cell side consisting of a 164$\mu$m thick EVA layer with a vinyl acetate content of 4.2 wt%, a 135 $\mu$m thick layer of polyester and a 26 $\mu$m thick layer of poly(vinylidene fluoride).

In the PID test the produced layer was used as Backsheet as given in the table 5.

**CompBS2:**

A 333 $\mu$m thick backsheet consisting of five different layers. From cell side consisting of a 88 $\mu$m thick EVA layer with a vinyl acetate content of 14.2 weight-%, a 36 $\mu$m thick further EVA layer having a vinyl acetate content of 9,5 weight-%, a 160 $\mu$m thick polyester layer, a 32 $\mu$m EVA layer having a vinyl acetate content of 9.5 weight-% and finally a 17$\mu$m layer of poly (tetra-fluoro ethylene) on the airside. In the PID test the produced layer was used as Backsheet as given in the table 5.

Table 5: Potential Induced degradation performance of inventive and comparative laminate structures

|  | Inv. 1 | Comp. 1 | Comp. 2 | Comp. 3 | Comp. 4 |
|---|---|---|---|---|---|
| Front Encapsulant | Inv LE5 | Comp EVA 1 | LE5 | LE5 | Comp EVA2 |
| Back Encapsulant | Inv LE5 | Comp EVA 1 | LE5 | LE5 | Comp EVA2 |
| Backsheet | Inv BS | Inv BS | Comp BS1 | Comp BS2 | Comp BS1 |
| EQE Prior PID, % | 93 | 93 | 93 | 93 | 93 |
| EQE Post PID, % | 93 | 75 | 78 | 60 | 5 |

**Claims**

**1.** An article comprising a layer element (LE) of at least two layers, first layer and second layer, wherein

- the first layer comprises (a) a copolymer of ethylene which is selected from

(a1) a copolymer of ethylene which bears silane group(s) containing units; or
(a2) a copolymer of ethylene with one or more polar comonomer(s) selected from ($C_1$-$C_6$)-alkyl acrylate or ($C_1$-$C_6$)-alkyl ($C_1$-$C_6$)-alkylacrylate comonomer(s), which copolymer (a2) bears silane group(s) containing units and which copolymer (a2) is different from the copolymer (a1); and

- the second layer comprises (b) a polymer of propylene (PP),

and wherein the first layer and second layer of the layer element (LE) are in adhering contact to each other, wherein the first layer of the layer element (LE) comprises more than 50 wt% of the copolymer of ethylene (a).

2. The article according to claim 1, wherein

- the copolymer of ethylene (a) is selected from

(a1) a copolymer of ethylene with silane group(s) containing comonomer; or
(a2) a copolymer of ethylene with one or more polar comonomer(s) selected from $(C_1-C_6)$-alkyl acrylate comonomer and with silane group(s) containing comonomer.

3. The article according to any of the preceding claims, wherein the polar comonomer is present in the copolymer of ethylene (a2) in an amount of 0.5 to 30.0 mol%, preferably the polar comonomer is selected from $(C_1-C_6)$-alkyl acrylate comonomer, more preferably from methyl acrylate, ethyl acrylate or butyl acrylate comonomer.

4. The article according to any of the preceding claims, wherein according to any of the preceding claims, wherein the silane group(s) containing unit or, preferably, the silane group(s) containing comonomer of copolymer of ethylene (a1) or of copolymer of ethylene (a2) is a hydrolysable unsaturated silane compound represented by the formula (I):

$$R^1SiR^2_qY_{3-q} \qquad (I)$$

wherein

$R^1$ is an ethylenically unsaturated hydrocarbyl, hydrocarbyloxy or (meth)acryloxy hydrocarbyl group,
each $R^2$ is independently an aliphatic saturated hydrocarbyl group,
Y which may be the same or different, is a hydrolysable organic group and
q is 0, 1 or 2;
preferably the amount of silane group(s) containing units or, preferably, of silane group(s) containing comonomer, present in the copolymer of ethylene (a1) or in the copolymer of ethylene (a2) is of 0.01 to 2.0 mol%;
preferably the copolymer of ethylene (a1) and the copolymer of ethylene (a2) are produced by polymerisation in a high pressure polymerisation process using a radical initiator.

5. The article according to any of the preceding claims, wherein

- the polymer of propylene (PP) (b) is a homopolymer or copolymer of propylene, suitably the polymer of propylene (PP) (b) is at least a copolymer of propylene;
preferably wherein the polymer of propylene (PP) (b) is a heterophasic copolymer of propylene (iPP) which comprises a heterophasic copolymer of propylene (A) which comprises,
- a polypropylene matrix component (a1) and
- an elastomeric propylene copolymer component (a2) which is dispersed in said polypropylene matrix (a1);
and wherein the heterophasic copolymer of propylene (A) has a Melting temperature (Tm) (DSC) of at least 145°C, when measured as described in the specification under Determination methods, and a Vicat softening temperature (Vicat A) of at least 90°C (according to ASTM D 1525, method A, 50°C/h, 10N).

6. The article according to any of the preceding claims, wherein heterophasic copolymer of propylene (A) has one or more, in any order, preferably all, of the following further properties:

$MFR_2$ of 0.2 to 20, preferably 0.2 to 15.0, preferably of 0.5 to 15, g/10 min when measured according to ISO 1133 (at 230°C and 2.16 kg load),
Xylene cold soluble (XCS) fraction in amount of 3 to 40, preferably of 5 to 37, wt%, when measured as described in specification under Determination methods,
Comonomer content of 0.5 to 20, preferably of 1.0 to 20, wt%, when measured as described in the specification under Determination methods, preferably the comonomer(s) is selected from ethylene and/or $C_4-C_8$ alpha olefin comonomers, more preferably from ethylene,

Tensile modulus of at least 700, preferably of 750 to 2500, MPa when measured according to ISO178 as described in the specification under Determination methods, and/or
Density of 900 to 910 kg/m3, when measured as described in the specification under Determination methods.

7. The article according to any of the preceding claims, wherein the second layer of the layer element (LE) comprises more than 25 wt%, preferably from 30 to 99.8 wt% of polymer of propylene (PP) (b).

8. The article according to any of the preceding claims, wherein at least one layer of the layer element (LE) comprises a filler, pigment, carbon black or flame retardant, preferably one of the at least two layers, preferably at least the second layer of the layer element (LE) comprises a pigment or filler.

9. The article according to any of the preceding claims, wherein the adhering surfaces of the first layer and the second layer of the layer element (LE) are in direct contact to each other or there is an adhesive layer between the adhering surfaces of the first layer and the second layer, preferably wherein the adhering surfaces of the first layer and the second layer of the layer element (LE) are in direct contact to each other.

10. The article according to any of the preceding claims, which is a multilayer film comprising the layer element (LE) of said at least two layers.

11. The article according to any of the preceding claims, which is an assembly comprising two or more layer elements, wherein at least one layer element is the layer element (LE) of said at least two layers.

12. The article according to any of the preceding claims, which is a photovoltaic (PV) module comprising a photovoltaic element and one or more further layer elements, wherein at least one layer element is the layer element (LE) of said at least two layers.

13. The photovoltaic (PV) module of claim 12 which comprises, in the given order, a protective front layer element, a front encapsulation layer element, a photovoltaic element and the layer element (LE) of said at least to layers as defined in any of the preceding claims 1 to 9.

14. The photovoltaic (PV) module of claim 12 or 13, wherein the side (=surface) of the first layer opposite to the side (=surface) adhering to the second layer of the layer element (LE) is in adhering contact with a photovoltaic element of the PV module.

15. A process for producing the layer element (LE) of the article according to any of the preceding claims comprising the step of

- adhering the first and second layer of the layer element (LE) together by extrusion or lamination and
- recovering the formed layer element (LE).

16. A process for producing a photovoltaic (PV) module according to any of the preceding claims 12 to 14 by

- assembling the photovoltaic element, the layer element (LE) and optional further layer elements to a photovoltaic (PV) module assembly;
- laminating the layer elements of the photovoltaic (PV) module assembly in elevated temperature to adhere the elements together; and
- recovering the obtained photovoltaic (PV) module.

17. The use of a protective back layer element comprising a polymer of propylene as the main polymeric component; and a front encapsulation layer element and a rear encapsulation layer element, which both encapsulation layer elements comprise as the main polymeric component in an amount of more than 50 wt%, preferably consist of, (a) a copolymer of ethylene which is selected from

(a1) a copolymer of ethylene which bears silane group(s) containing units; or
(a2) a copolymer of ethylene with one or more polar comonomer(s) selected from $(C_1-C_6)$-alkyl acrylate or $(C_1-C_6)$-alkyl $(C_1-C_6)$-alkylacrylate comonomer(s), which copolymer (a2) bears silane group(s) containing units and which copolymer (a2) is different from the copolymer (a1); for increasing the resistance against Potential Induced Degradation (PID) or even preventing Potential Induced Degradation (PID) of a photovoltaic (PV) module comprising, in a given order, a protective front layer element, said front encapsulation layer element, a photovoltaic element, said rear encapsulation layer element and said protective back layer element.

18. The use according to claim 17, wherein the polymer of propylene of the protective back layer element and the polymer (a) of the front encapsulation layer element and the rear encapsulation layer element are as defined in any of the preceding claims 1 to 8, preferably wherein the polymer (a) is a (a2) a copolymer of ethylene with one or more polar comonomer(s) selected from $(C_1-C_6)$-alkyl acrylate or $(C_1-C_6)$-alkyl $(C_1-C_6)$-alkylacrylate comonomer(s ), which copolymer (a2) bears silane group(s) containing units, as defined in any of the preceding claims 1 to 8.

**Patentansprüche**

1. Gegenstand enthaltend ein Schichtelement (LE) aus mindestens zwei Schichten, einer ersten Schicht und einer zweiten Schicht, wobei

   - die erste Schicht (a) ein Ethylen-Copolymer umfasst, das ausgewählt ist aus

   (a1) einem Ethylen-Copolymer, das Einheiten trägt, die Silangruppe(n) enthalten, oder
   (a2) einem Ethylen-Copolymer mit einem oder mehreren polaren Comonomer(en), ausgewählt aus $(C_1-C_6)$-Alkylacrylat- oder $(C_1-C_6)$-Alkyl-$(C_1-C_6)$-Alkylacrylat-Comonomer(en), wobei das Copolymer (a2) Einheiten trägt, die Silangruppe(n) enthalten, und das Copolymer (a2) von dem Copolymer (a1) verschieden ist; und

   - die zweite Schicht (b) ein Polymer aus Propylen (PP) umfasst,

   und wobei die erste Schicht und die zweite Schicht des Schichtelements (LE) in Haftkontakt zueinander stehen,
   wobei die erste Schicht des Schichtelements (LE) mehr als 50 Gew.-% des Ethylen-Copolymers (a) umfasst.

2. Der Gegenstand nach Anspruch 1, wobei

   - das Ethylen-Copolymer (a) ausgewählt ist aus

   (a1) einem Ethylen-Copolymer mit Silangruppe(n) enthaltendem Comonomer; oder
   (a2) einem Ethylen-Copolymer mit einem oder mehreren polaren Comonomer(en), ausgewählt aus $(C_1-C_6)$-Alkylacrylatcomonomer und mit Silangruppe(n) enthaltendem Comonomer.

3. Der Gegenstand nach einem der vorhergehenden Ansprüche, wobei das polare Comonomer in dem Ethylen-Copolymer (a2) in einer Menge von 0,5 bis 30,0 Mol-% vorhanden ist, vorzugsweise ist das polare Comonomer aus-gewählt aus $(C_1-C_6)$-Alkylacrylat-Comonomer, bevorzugter aus Methylacrylat-, Ethylacrylat- oder Butylacrylat-Comonomer.

4. Der Gegenstand nach einem der vorhergehenden Ansprüche, wobei nach einem der vorhergehenden Ansprüche die Einheit, die Silangruppe(n) enthält, oder vorzugsweise das (die) Silangruppe(n) enthaltende Comonomer des Ethylen-Copolymers (a1) oder des Ethylen-Copolymers (a2) eine hydrolysierbare ungesättigte Silanverbindung der Formel (I) ist:

$$R^1SiR^2_qY_{3-q} \qquad (I)$$

wobei

$R^1$ eine ethylenisch ungesättigte Hydrocarbyl-, Hydrocarbyloxy- oder (Meth)acryloxy-Hydrocarbylgruppe ist,
jedes $R^2$ unabhängig voneinander eine aliphatische gesättigte Hydrocarbylgruppe ist,
Y, das gleich oder verschieden sein kann, eine hydrolysierbare organische Gruppe ist und
q 0, 1 oder 2 ist;
vorzugsweise beträgt die Menge an Einheiten, die Silangruppe(n) enthalten, oder vorzugsweise an Silangruppe(n) enthaltendem Comonomer, die im Ethylen-Copolymer (a1) oder im Ethylen-Copolymer (a2) vorhanden sind, 0,01 bis 2,0 Mol-%;

vorzugsweise werden das Ethylen-Copolymer (a1) und das Ethylen-Copolymer (a2) durch Polymerisation in einem

Hochdruckpolymerisationsverfahren unter Verwendung eines Radikalinitiators hergestellt.

5.  Der Gegenstand nach einem der vorhergehenden Ansprüche, wobei

   - das Polymer aus Propylen (PP) (b) ein Homopolymer oder Copolymer von Propylen ist, wobei das Polymer aus Propylen (PP) (b) geeigneterweise mindestens ein Copolymer von Propylen ist;
   wobei das Polymer aus Propylen (PP) (b) vorzugsweise ein heterophasisches Copolymer von Propylen (iPP) ist, das ein heterophasisches Copolymer von Propylen (A) umfasst, das Folgendes umfasst:
   - eine Polypropylen-Matrixkomponente (a1) und
   - eine elastomere Propylen-Copolymer-Komponente (a2), die in dieser Polypropylenmatrix (a1) dispergiert ist; und wobei das heterophasige Copolymer von Propylen (A) eine Schmelztemperatur (Tm) (DSC) von mindestens 145°C, gemessen wie in der Beschreibung unter Bestimmungsmethoden beschrieben, und eine Vicat-Erweichungstemperatur (Vicat A) von mindestens 90°C (gemäß ASTM D 1525, Methode A, 50°C/h, 10N) aufweist.

6.  Der Gegenstand nach einem der vorhergehenden Ansprüche, wobei das heterophasige Copolymer von Propylen (A) eine oder mehrere, in beliebiger Reihenfolge, vorzugsweise alle, der folgenden weiteren Eigenschaften aufweist:

   $MFR_2$ von 0,2 bis 20, vorzugsweise von 0,2 bis 15,0, vorzugsweise von 0,5 bis 15, g/10 min, gemessen nach ISO 1133 (bei 230°C und 2,16 kg Last),
   Kaltlösliche Xylol-Fraktion (XCS) in einer Menge von 3 bis 40, vorzugsweise von 5 bis 37 Gew.-%, gemessen wie in der Beschreibung unter Bestimmungsmethoden beschrieben,
   Comonomergehalt von 0,5 bis 20, vorzugsweise von 1,0 bis 20 Gew.-%, gemessen wie in der Beschreibung unter Bestimmungsmethoden beschrieben, wobei das/die Comonomer(e) vorzugsweise aus Ethylen und/oder $C_4$ -$C_8$ -alpha-Olefin-Comonomeren, besonders bevorzugt aus Ethylen, ausgewählt ist/sind,
   Zugmodul von mindestens 700, vorzugsweise von 750 bis 2500, MPa, gemessen nach ISO178, wie in der Brschreibung unter Bestimmungsmethoden beschrieben, und/oder
   Dichte von 900 bis 910 kg/m3, gemessen wie in der Beschreibung unter Bestimmungsmethoden beschrieben.

7.  Der Gegenstand nach einem der vorhergehenden Ansprüche, wobei die zweite Schicht des Schichtelements (LE) mehr als 25 Gew.-%, vorzugsweise 30 bis 99,8 Gew.-%, des Polymers aus Propylen (PP) (b) enthält.

8.  Der Gegenstand nach einem der vorhergehenden Ansprüche, wobei mindestens eine Schicht des Schichtelements (LE) einen Füllstoff, ein Pigment, Ruß oder Flammschutzmittel enthält, vorzugsweise eine der mindestens zwei Schichten, vorzugsweise mindestens die zweite Schicht des Schichtelements (LE) ein Pigment oder einen Füllstoff enthält.

9.  Der Gegenstand nach einem der vorhergehenden Ansprüche, wobei die Haftflächen der ersten Schicht und der zweiten Schicht des Schichtelements (LE) in direktem Kontakt zueinander stehen oder eine Haftschicht zwischen den Haftflächen der ersten Schicht und der zweiten Schicht vorhanden ist, vorzugsweise wobei die Haftflächen der ersten Schicht und der zweiten Schicht des Schichtelements (LE) in direktem Kontakt zueinander stehen.

10.  Der Gegenstand nach einem der vorhergehenden Ansprüche, der eine mehrschichtige Folie ist, die das Schichtelement (LE) der mindestens zwei Schichten umfasst.

11.  Der Gegenstand nach einem der vorhergehenden Ansprüche, der eine Baugruppe ist, die zwei oder mehr Schichtelemente enthält, wobei mindestens ein Schichtelement das Schichtelement (LE) der mindestens zwei Schichten ist.

12.  Der Gegenstand nach einem der vorhergehenden Ansprüche, der ein Photovoltaik (PV) Modul ist, das ein photovoltaisches Element und ein oder mehrere weitere Schichtelemente umfasst, wobei mindestens ein Schichtelement das Schichtelement (LE) der mindestens zwei Schichten ist.

13.  Das Photovoltaik (PV)-Modul nach Anspruch 12, das in der angegebenen Reihenfolge ein schützendes vorderes Schichtelement, ein vorderes Verkapselungsschichtelement, ein photovoltaisches Element und das Schichtelement (LE) der mindestens zwei Schichten, wie in einem der vorhergehenden Ansprüche 1 bis 9 definiert, umfasst.

**14.** Das Photovoltaik (PV)-Modul nach Anspruch 12 oder 13, wobei die Seite (=Oberfläche) der ersten Schicht, die der Seite (=Oberfläche) gegenüberliegt, die an der zweiten Schicht des Schichtelements (LE) haftet, in Haftkontakt mit einem photovoltaischen Element des PV-Moduls steht.

**15.** Verfahren zur Herstellung des Schichtelements (LE) des Gegenstands nach einem der vorhergehenden Ansprüche, umfassend den Schritt

- in Haftung bringen der ersten und zweiten Schicht des Schichtelements (LE) durch Extrusion oder Laminierung und
- Erhalten des gebildeten Schichtelements (LE).

**16.** Verfahren zur Herstellung eines Photovoltaik (PV) Moduls nach einem der vorangehenden Ansprüche 12 bis 14 durch

- Zusammenfügen des photovoltaischen Elements, des Schichtelements (LE) und optional weiterer Schichtelemente zu einer Photovoltaik (PV) Modulanordnung;
- Laminieren der Schichtelemente der Photovoltaik (PV) Modulanordnung bei erhöhter Temperatur, um die Elemente miteinander in Haftung zu bringen; und
- Erhalten des erhaltenen Photovoltaik (PV) Moduls.

**17.** Verwendung eines schützenden Rückschichtelements, das ein Polymer aus Propylen als Hauptpolymerkomponente umfasst; und eines vorderen Verkapselungsschichtelements und eines hinteren Verkapselungsschichtelements, wobei beide Verkapselungsschichtelemente als Hauptpolymerkomponente in einer Menge von mehr als 50 Gew.-% Folgendes umfassen, vorzugsweise aus Folgendem bestehen: (a) ein Ethylen-Copolymer, das ausgewählt ist aus

a1) einem Ethylen-Copolymer, das Einheiten trägt, die Silangruppe(n) enthalten, oder
(a2) einem Ethylen-Copolymer mit einem oder mehreren polaren Comonomer(en), ausgewählt aus ($C_1$-$C_6$)-Alkylacrylat- oder ($C_1$-$C_6$)-Alkyl-($C_1$-$C_6$)-Alkylacrylat-Comonomer(en), wobei das Copolymer (a2) Einheiten trägt, die Silangruppe(n) enthalten, und das Copolymer (a2) von dem Copolymer (a1) verschieden ist; zum Erhöhen der Beständigkeit gegen potentiell induzierte Degradation (PID) oder sogar zum Verhindern von potentiell induzierter Degradation (PID) eines Photovoltaik (PV) Moduls, das in einer gegebenen Reihenfolge ein schützendes vorderes Schichtelement, das vordere Verkapselungsschichtelement, ein photovoltaisches Element, das hintere Verkapselungsschichtelement und das schützende Rückschichtelement umfasst.

**18.** Verwendung nach Anspruch 17, wobei das Polymer aus Propylen des schützenden Rückschichtelements und das Polymer (a) des vorderen Verkapselungsschichtelements und des hinteren Verkapselungsschichtelements wie in einem der vorhergehenden Ansprüche 1 bis 8 definiert sind, wobei das Polymer (a) vorzugsweise ein (a2) Ethylen-Copolymer mit einem oder mehreren polaren Comonomer(en), ausgewählt aus ($C_1$-$C_6$)-Alkylacrylat oder ($C_1$-$C_6$)-Alkyl ($C_1$-$C_6$)-Alkylacrylat Comonomer(en), ist, wobei das Copolymer (a2) Einheiten trägt, die Silangruppe(n) enthalten, wie in einem der vorangehenden Ansprüche 1 bis 8 definiert.

**Revendications**

**1.** Article comprenant un élément de couche (LE) d'au moins deux couches, une première couche et une deuxième couche, dans lequel

- la première couche comprend (a) un copolymère d'éthylène qui est choisi parmi

(a1) un copolymère d'éthylène qui porte des motifs contenant un ou plusieurs groupes silane ; ou
(a2) un copolymère d'éthylène et d'un ou plusieurs comonomères polaires choisis parmi un ou plusieurs comonomères d'acrylate d'alkyle en $C_1$ à $C_6$ ou de (alkyle en $C_1$ à $C_6$)acrylate d'alkyle en $C_1$ à $C_6$, lequel copolymère (a2) porte des motifs contenant un ou plusieurs groupes silane et lequel copolymère (a2) est différent du copolymère (a1) ; et

- la deuxième couche comprend (b) un polymère de propylène (PP),

et dans lequel la première couche et la deuxième couche de l'élément de couche (LE) sont en contact adhérent l'une avec l'autre,

dans lequel la première couche de l'élément de couche (LE) comprend plus de 50 % en poids du copolymère d'éthylène (a) .

**2.** Article selon la revendication 1, dans lequel

- le copolymère d'éthylène (a) est choisi parmi

(a1) un copolymère d'éthylène et d'un comonomère contenant un ou plusieurs groupes silane ; ou
(a2) un copolymère d'éthylène et d'un ou plusieurs comonomères polaires choisi parmi les comonomères d'acrylate d'alkyle en $C_1$ à $C_6$ et d'un comonomère contenant un ou plusieurs groupes silane.

**3.** Article selon l'une quelconque des revendications précédentes, dans lequel le comonomère polaire est présent dans le copolymère d'éthylène (a2) en une quantité de 0,5 à 30,0 % en moles, de préférence le comonomère polaire est choisi parmi les comonomères d'acrylate d'alkyle en $C_1$ à $C_6$, plus préférablement parmi les comonomères d'acrylate de méthyle, d'acrylate d'éthyle et d'acrylate de butyle.

**4.** Article selon l'une quelconque des revendications précédentes, dans lequel le motif contenant un ou plusieurs groupes silane ou, de préférence, le comonomère contenant un ou plusieurs groupes silane du copolymère d'éthylène (a1) ou du copolymère d'éthylène (a2) est un composé silane insaturé hydrolysable représenté par la formule (I) :

$$R^1SiR^2_qY_{3-q} \qquad (I)$$

$R^1$ est un groupe (méth)acryloxyhydrocarbyle, hydrocarbyloxy ou hydrocarbyle à insaturation éthylénique,
chaque $R^2$ est indépendamment un groupe hydrocarbyle saturé aliphatique,
chacun des Y, qui peuvent être identiques ou différents, est un groupe organique hydrolysable, et
q vaut 0, 1 ou 2 ;
de préférence la quantité de motifs contenant un ou plusieurs groupes silane ou, de préférence, du comonomère contenant un ou plusieurs groupes silane, présents dans le copolymère d'éthylène (a1) ou dans le copolymère d'éthylène (a2) et de 0,01 à 2,0 % en moles ;
de préférence le copolymère d'éthylène (a1) et le copolymère d'éthylène (a2) sont produits par polymérisation dans un procédé de polymérisation haute pression utilisant un amorceur radicalaire.

**5.** article selon l'une quelconque des revendications précédentes, dans lequel

- le polymère de propylène (PP) (b) est un homopolymère ou copolymère de propylène, de façon convenable le polymère de propylène (PP) (b) est au moins un copolymère de propylène ;
de préférence dans lequel le polymère de propylène (PP) (b) est un copolymère hétérophasique de propylène (iPP) qui comprend un copolymère hétérophasique du propylène (A) qui comprend
- un composant matrice de polypropylène (a1) et
- un composant copolymère de propylène élastomère (a2) qui est dispersé dans ladite matrice de polypropylène (a1) ;
et dans lequel le copolymère hétérophasique de propylène (A) a un point de fusion (Tm) (DSC) d'au moins 145°C, quand il est mesuré comme décrit dans le fascicule à la rubrique Méthodes de détermination, et un point de ramollissement Vicat (Vicat A) d'au moins 90°C (conformément à la norme ASTM D 1525, méthode A, 50°C/h, 10N).

**6.** Article selon l'une quelconque des revendications précédentes, dans lequel le copolymère hétérophasique de propylène (A) a une ou plusieurs, dans un ordre quelconque, de préférence la totalité, des autres propriétés suivantes :

un $MFR_2$ de 0,2 à 20, de préférence de 0,2 à 15,0, de préférence de 0,5 à 15 g/10 min quand il est mesuré conformément à la norme ISO 1133 (à 230°C et sous une charge de 2,16 kg),
une fraction soluble à froid dans le xylène (XCS) en une quantité de 3 à 40, de préférence de 5 à 37 % en poids, quand elle est mesurée comme décrit dans le fascicule à la rubrique Méthodes de détermination,
une teneur en comonomères de 0,5 à 20, de préférence de 1,0 à 20 % en poids, quand elle est mesurée comme décrit dans le fascicule à la rubrique Méthodes de détermination, de préférence le ou les comonomères étant choisis parmi l'éthylène et/ou les comonomères d'alpha-oléfine en $C_4$ à $C_8$, plus préférablement parmi l'éthylène, un module de traction d'au moins 700, de préférence de 750 à 2500 MPa quand il est mesuré conformément à la norme ISO 178 comme décrit dans le fascicule à la rubrique Méthodes de détermination, et/ou

une masse volumique de 900 à 910 kg/m$^3$, quand elle est mesurée comme décrit dans le fascicule à la rubrique Méthodes de détermination.

7. Article selon l'une quelconque des revendications précédentes, dans lequel la deuxième couche de l'élément de couche (LE) comprend plus de 25 % en poids, de préférence de 30 à 99,8 % en poids de polymère de propylène (PP) (b).

8. Article selon l'une quelconque des revendications précédentes, dans lequel au moins une couche de l'élément de couche (LE) comprend une charge, un pigment, du noir de carbone ou un retardateur d'inflammation, de préférence l'une des au moins deux couches, de préférence au moins la deuxième couche de l'élément de couche (LE) comprend un pigment ou une charge.

9. Article selon l'une quelconque des revendications précédentes, dans lequel les surfaces adhérentes de la première couche et de la deuxième couche de l'élément de couche (LE) sont en contact direct l'une avec l'autre, ou bien il y a une couche adhésive entre les surfaces adhérentes de la première couche et de la deuxième couche, de préférence dans lequel les surfaces adhérentes de la première couche et de la deuxième couche de l'élément de couche (LE) sont en contact direct l'une avec l'autre.

10. Article selon l'une quelconque des revendications précédentes, qui est un film multicouche comprenant l'élément de couche (LE) desdites au moins deux couches.

11. Article selon l'une quelconque des revendications précédentes, qui est un assemblage comprenant deux ou plus de deux éléments de couches, dans lequel au moins un élément de couche est l'élément de couche (LE) desdites au moins deux couches.

12. Article selon l'une quelconque des revendications précédentes, qui est un module photovoltaïque (PV) comprenant un élément photovoltaïque et un ou plusieurs autres éléments de couches, dans lequel au moins un élément de couche est l'élément de couche (LE) desdites au moins deux couches.

13. Module photovoltaïque (PV) selon la revendication 12, qui comprend, dans l'ordre indiqué, un élément de couche avant protecteur, un élément de couche d'encapsulation avant, un élément photovoltaïque et l'élément de couche (LE) desdites au moins deux couches tel que défini dans l'une quelconque des revendications 1 à 9.

14. Module photovoltaïque (PV) selon la revendication 12 ou 13, dans lequel le côté (= surface) de la première couche opposé au côté (= surface) adhérant à la deuxième couche de l'élément de couche (LE) est en contact adhérent avec un élément photovoltaïque du module PV.

15. Procédé pour produire l'élément de couche (LE) de l'article selon l'une quelconque des revendications précédentes, comprenant les étapes suivantes :

    - adhérence ensemble des première et deuxième couches de l'élément de couche (LE) par extrusion ou stratification et
    - récupération de l'élément de couche (LE) formé.

16. Procédé pour produire un module photovoltaïque (PV) selon l'une quelconque des revendications 12 à 14, par

    - assemblage de l'élément photovoltaïque, de l'élément de couche (LE) et d'autres éléments de couches optionnels en un assemblage de module photovoltaïque (PV) ;
    - stratification des éléments de couches de l'assemblage de module photovoltaïque (PV) à une température élevée pour que les éléments adhèrent ensemble ; et
    - récupération du module photovoltaïque (PV) obtenu.

17. Utilisation d'un élément de couche arrière protecteur comprenant un polymère de propylène en tant que composant polymère principal ; et un élément de couche d'encapsulation avant et un élément de couche d'encapsulation arrière, les deux éléments de couches d'encapsulation comprenant en tant que composant polymère principal en une quantité supérieure à 50 % en poids, de préférence consistant en, (a) un copolymère d'éthylène qui est choisi parmi

    (a1) un copolymère d'éthylène qui porte des motifs contenant un ou plusieurs groupes silane ; ou

(a2) un copolymère d'éthylène et d'un ou plusieurs comonomères polaires choisis parmi un ou plusieurs comonomères d'acrylate d'alkyle en $C_1$ à $C_6$ ou de (alkyle en $C_1$ à $C_6$)acrylate d'alkyle en $C_1$ à $C_6$, lequel copolymère (a2) porte des motifs contenant un ou plusieurs groupes silane et lequel copolymère (a2) est différent du copolymère (a1) ;

pour augmenter la résistance à la dégradation induite par le potentiel (PID) ou même empêcher la dégradation induite par le potentiel (PID) d'un module photovoltaïque (PV) comprenant, dans l'ordre indiqué, un élément de couche avant protecteur, ledit élément de couche d'encapsulation avant, un élément photovoltaïque, ledit élément de couche d'encapsulation arrière et ledit élément de couche arrière protecteur.

18. Utilisation selon la revendication 17, dans laquelle le polymère de propylène de l'élément de couche arrière protecteur et le polymère (a) de l'élément de couche d'encapsulation avant et de l'élément de couche d'encapsulation arrière sont tels que définis dans l'une quelconque des revendications 1 à 8, de préférence dans laquelle le polymère (a) est (a2) un copolymère d'éthylène et d'un ou plusieurs comonomères polaires choisis parmi un ou plusieurs comonomères d'acrylate d'alkyle en $C_1$ à $C_6$ ou de (alkyle en $C_1$ à $C_6$) acrylate d'alkyle en $C_1$ à $C_6$, lequel copolymère (a2) porte des motifs contenant un ou plusieurs groupes silane, comme défini dans l'une quelconque des revendications 1 à 8.

## Figure 1

## Figure 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013003541 A1
- WO 2015173175 A1
- EP 2660877 A2
- US 20150013753 A1
- WO 2011160964 A, Borealis
- EP 736065 A
- EP 1309631 A
- EP 1309632 A
- EP 0887379 A
- WO 9212182 A
- WO 2004000899 A
- WO 2004111095 A
- WO 9924478 A
- WO 9924479 A
- WO 0068315 A
- WO 8707620 A
- WO 9221705 A
- WO 9311165 A
- WO 9311166 A
- WO 9319100 A
- WO 9736939 A
- WO 9812234 A
- WO 9933842 A
- WO 03000756 A
- WO 03000757 A
- WO 03000754 A
- WO 03000755 A
- WO 2004029112 A
- EP 2610271 A

- WO 2012007430 A
- WO 9219659 A
- WO 9219653 A
- WO 9219658 A
- US 4382019 A
- US 4435550 A
- US 4465782 A
- US 4473660 A
- US 4560671 A
- US 5539067 A
- US 5618771 A
- EP 45975 A
- EP 45976 A
- EP 45977 A
- WO 9532994 A
- US 4107414 A
- US 4186107 A
- US 4226963 A
- US 4347160 A
- US 4472524 A
- US 4522930 A
- US 4530912 A
- US 4532313 A
- US 4657882 A
- US 4581342 A
- EP 491566 A
- EP 591224 A
- EP 586390 A

**Non-patent literature cited in the description**

- *Encyclopedia of Polymer Science and Engineering,* 1986, vol. 6, 383-410
- Polyethylene: High-pressure. **R.KLIMESCH ; D.LITTMANN ; F.-O. MÄHLING.** Encyclopedia of Materials: Science and Technology. Elsevier Science Ltd, 2001, 7181-7184
- Plastic Additives Handbook. Hans Zweifel, 2001
- *CHEMICAL ABSTRACTS,* 128-37-0
- **J. RANDALL.** *Macromol. Sci., Rev. Macromol. Chem. Phys.,* 1989, vol. C29, 201
- **HEINO, E.L. ; LEHTINEN, A. ; TANNER J. ; SEP-PÄLÄ, J.** Rheological characterization of polyethylene fractions. *Neste Oy, Porvoo, Finland, Theor. Appl. Rheol., Proc. Int. Congr. Rheol, 11th,* 1992, vol. 1, 360-362

- **HEINO, E.L.** The influence of molecular structure on some rheological properties of polyethylene. *Borealis Polymers Oy, Porvoo, Finland, Annual Transactions of the Nordic Rheology Society,* 1995
- Definition of terms relating to the non-ultimate mechanical properties of polymers. *Pure & Appl. Chem.,* 1998, vol. 70 (3), 701-754
- *CHEMICAL ABSTRACTS,* 32687-78-8
- *CHEMICAL ABSTRACTS,* 71878-19-8